# EUROPEAN PATENT APPLICATION

(11) **EP 4 808 021 A1**
(43) Date of publication of application: **16.09.2026**
(21) Application number: 24893419.2
(22) Date of filing: 19.11.2024
(51) Int. Cl.: H04L 1/00, H03M 13/11, H03M 13/00

(54) **COMMUNICATION METHOD AND APPARATUS**

(30) Priority: 24.11.2023 CN 202311597604
(71) Applicant: Huawei Technologies Co., Ltd., Shenzhen, Guangdong 518129 (CN)
(72) Inventor: LIU, Ke, Shenzhen, Guangdong 518129 (CN); ZHANG, Huazi, Shenzhen, Guangdong 518129 (CN); TONG, Jiajie, Shenzhen, Guangdong 518129 (CN); QIN, Kangjian, Shenzhen, Guangdong 518129 (CN); WANG, Xianbin, Shenzhen, Guangdong 518129 (CN); WANG, Jun, Shenzhen, Guangdong 518129 (CN)
(74) Representative: Maiwald GmbH
(86) International application number: PCT/CN2024/132930
(87) International publication number: WO 2025/108262

(57) **Abstract**

A communication method and apparatus are provided, and relate to the field of communication technologies, to improve hardware resource utilization, and in particular, improve decoding performance. The method includes: A transmitting device determines, based on an information bit sequence, sets of numbers of information columns associated with M base graphs corresponding to the information bit sequence and sets of lifting sizes associated with the M base graphs; determines, based on first information, a number of information columns associated with a code length interval corresponding to a length of the information bit sequence as a target number of information columns; and determines, from the M base graphs based on the target number of information columns, a base graph corresponding to the target number of information columns, where M is a positive integer greater than or equal to 2, the first information indicates a number of information columns associated with each of a plurality of code length intervals, the number of information columns associated with the code length interval is determined based on the sets of numbers of information columns and/or the sets of lifting sizes, and the base graph is used to encode the information bit sequence to obtain an encoded bit sequence.

## Description

This application claims priority to Chinese Patent Application No. 202311597604.4, filed with the China National Intellectual Property Administration on November 24, 2023 and entitled "COMMUNICATION METHOD AND APPARATUS", which is incorporated herein by reference in its entirety.

### TECHNICAL FIELD

This application relates to the field of communication technologies, and in particular, to a communication method and apparatus.

### BACKGROUND

Low-density parity-check (low density parity check, LDPC) codes are a type of channel encoding scheme. A transmitting device may encode an information bit sequence based on LDPC codes. Correspondingly, a receiving device may decode to-be-decoded information based on the LDPC codes. The transmitting device or the receiving device may determine a number of information columns of a base graph (basic graph, BG) based on a length of the information bit sequence, and then determine a lifting size (lifting size, LS) based on the number of information columns of the base graph.

When the lifting size is less than a maximum lifting size supported by the receiving device, the receiving device may perform parallel decoding across multiple blocks and multiple packets, to maximize hardware resource utilization during decoding.

However, in high throughput scenarios, there are still information bit sequences with some lengths (for example, these lengths may be lengths greater than half of a maximum length of the information bit sequence) that has low hardware resource utilization during decoding, causing a waste of hardware resources.

### SUMMARY

Embodiments of this application provide a communication method and apparatus, to improve hardware resource utilization, and in particular, improve decoding performance.

According to a first aspect, a communication method is provided. The method may be performed by a transmitting device. Unless otherwise specified, the "transmitting device" in this application may be the transmitting device, may be a component (for example, a processor, a chip, or a chip system) in the transmitting device, or may be a logical module or software that can implement all or some functions of the transmitting device. The method includes: The transmitting device determines, based on an information bit sequence, sets of numbers of information columns associated with M base graphs corresponding to the information bit sequence and sets of lifting sizes associated with the M base graphs; determines, based on first information, a number of information columns associated with a code length interval corresponding to a length of the information bit sequence as a target number of information columns; and determines, from the M base graphs based on the target number of information columns, a base graph corresponding to the target number of information columns, where M is a positive integer greater than or equal to 2, the first information indicates a number of information columns associated with each of a plurality of code length intervals, the number of information columns associated with the code length interval is determined based on the sets of numbers of information columns and/or the sets of lifting sizes, and the base graph is used to encode the information bit sequence to obtain an encoded bit sequence.

According to the foregoing solution, the transmitting device may determine the code length interval corresponding to the length of the information bit sequence, to explicitly determine, based on the first information, the number of information columns associated with the code length interval as the target number of information columns, thereby reducing computational complexity, and improving working efficiency of the transmitting device. In addition, different from determining, by the transmitting device, one base graph based on the information bit sequence, in this application, the M base graphs can be determined based on the information bit sequence. The M base graphs correspond to different numbers of information columns. The base graphs corresponding to the different numbers of information columns can reduce an overlapping peak area of a waste of resources, to greatly reduce a proportion of idle hardware resources, and further improve hardware resource utilization during decoding of to-be-decoded information of different lengths. Moreover, the transmitting device determines, from the M base graphs based on the target number of information columns, the base graph used for encoding (for example, when the target number of information columns corresponds to at least two base graphs, the base graph used for encoding may be determined from the M base graphs based on an actual communication scenario), to further improve hardware resource utilization, and in particular, improve decoding performance.

According to a second aspect, a communication method is provided. The method may be performed by a receiving device. Unless otherwise specified, the "receiving device" in this application may be the receiving device, may be a component (for example, a processor, a chip, or a chip system) in the receiving device, or may be a logical module or software that can implement all or some functions of the receiving device. The method includes: The receiving device obtains to-be-decoded information from a transmitting device, and determines a length of an information bit sequence corresponding to the to-be-decoded information, sets of numbers of information columns associated with M base graphs corresponding to the information bit sequence, and sets of lifting sizes associated with the M base graphs; determines, based on first information, a number of information columns associated with a code length interval corresponding to the length of the information bit sequence as a target number of information columns; and decodes the to-be-decoded information based on the target number of information columns and a target lifting size, to obtain a decoded information bit sequence, where M is greater than or equal to 2, the first information indicates a number of information columns associated with each of a plurality of code length intervals, the number of information columns associated with the code length interval is determined based on the sets of numbers of information columns and/or the sets of lifting sizes, and the target lifting size is determined based on the sets of lifting sizes.

According to the foregoing solution, the receiving device may determine the code length interval corresponding to the length of the information bit sequence, to explicitly determine, based on the first information, the number of information columns associated with the code length interval as the target number of information columns, thereby reducing computational complexity, and improving working efficiency of the receiving device. In addition, different from determining, by the receiving device, one base graph based on the information bit sequence, in this application, the M base graphs can be determined based on the information bit sequence, to improve hardware resource utilization during decoding of to-be-decoded information of different lengths, and further improve decoding performance.

With reference to the first aspect and the second aspect, in a possible implementation, when the first information indicates Q code length intervals and P numbers of information columns, the Q code length intervals include a plurality of code length interval groups, the plurality of code length interval groups are associated with a same set of numbers of information columns, and the set of numbers of information columns associated with the plurality of code length interval groups includes a plurality of numbers of information columns among the P numbers of information columns, where Q and P are positive integers.

Based on this possible implementation, a number of information columns associated with each code length interval in each code length interval group can be determined. When a mark number of a code length interval increases, a number of information columns associated with the code length interval can be directly determined based on the plurality of numbers of information columns among the P numbers of information columns, thereby improving working efficiency of the transmitting device or the receiving device, and providing a feasible solution for determining the number of information columns associated with the code length interval.

With reference to the first aspect and the second aspect, in a possible implementation, a number of information columns associated with a first code length interval is a first number of information columns, and a number of information columns associated with a second code length interval is a second number of information columns, where each length value within the first code length interval is less than or equal to a first threshold, and each length value within the second code length interval is greater than the first threshold.

Based on this possible implementation, the code length intervals may be divided based on a relationship between each length value and the first threshold, to provide a feasible solution for dividing the code length intervals. Further, the number of information columns corresponding to the information bit sequence can be determined by comparing the length of the information bit sequence with the first threshold, thereby improving working efficiency of determining, by the transmitting device or the receiving device, the number of information columns corresponding to the information bit sequence.

With reference to the first aspect and the second aspect, in a possible implementation, there are a first number *K*₁ of information columns and a second number *K*₂ of information columns, and *K*₁ is less than *K*₂. A first code length interval is $\left(\frac{{K}_{1} \times {Z}_{max}}{z + 1}+1,\frac{{K}_{2} \times {Z}_{max}}{z + 1}\right]$, and a number of information columns associated with the first code length interval is *K*₂. A second code length interval is $\left(\frac{{K}_{2} \times {Z}_{max}}{z + 1}+1,\frac{{K}_{1} \times {Z}_{max}}{z}\right]$, and a number of information columns associated with the second code length interval is *K*₁. z is a positive integer, *Zₘₐₓ* is a first value, and the first value is a predefined maximum lifting size.

Based on this possible implementation, an endpoint of the code length interval can be determined based on the number of information columns, or the number of information columns associated with the code length interval can be determined based on the endpoint of the code length interval. In addition, as a value of z increases, endpoints of different code length intervals can be determined based on the number of information columns. In other words, the different code length intervals are associated with the same numbers of information columns. This provides a feasible solution for determining the endpoint of the code length interval and the number of information columns associated with the code length interval.

With reference to the first aspect and the second aspect, in a possible implementation, the number of information columns associated with the code length interval is determined based on the target lifting size, where the target lifting size is determined by comparing X first metrics, an x^{th} first metric among the X first metrics is determined based on the first value and an i^{th} lifting size in a first set of lifting sizes, the first set of lifting sizes is determined based on the sets of lifting sizes and the sets of numbers of information columns, the first value is the predefined maximum lifting size, the i^{th} lifting size corresponds to a j^{th} number of information columns in the sets of numbers of information columns, X is greater than or equal to 2, and x=1, 2, ..., X.

Based on this possible implementation, different from determining, by the transmitting device or the receiving device, the target number of information columns based on the length of the information bit sequence, and then determining the target lifting size based on the target number of information columns, in this application, the target lifting size can be determined by comparing the X first metrics. In this way, more feasible solutions can be provided for determining the target lifting size. In addition, it can be ensured that hardware resources are wasted as little as possible during determining of the target lifting size, thereby improving hardware resource utilization, and in particular, improving decoding performance.

With reference to the first aspect and the second aspect, in a possible implementation, the i^{th} lifting size is a minimum lifting size that is in the sets of lifting sizes and that supports the j^{th} number of information columns in meeting a second condition, where the second condition is that a product of the j^{th} number of information columns and a lifting size in the sets of lifting sizes is greater than or equal to each length value in the code length interval. Alternatively, the j^{th} number of information columns is a minimum number of information columns that is in the sets of numbers of information columns and that supports the i^{th} lifting size in meeting a third condition, where the third condition is that a product of the i^{th} lifting size and a number of information columns in the sets of numbers of information columns is greater than or equal to each length value in the code length interval.

Based on this possible implementation, by using the foregoing method, the lifting size corresponding to the j^{th} number of information columns or the number of information columns corresponding to the i^{th} lifting size can be determined, to provide two feasible solutions for determining a correspondence between numbers of information columns and lifting sizes.

With reference to the first aspect and the second aspect, in a possible implementation, each lifting size in the first set of lifting sizes and a number of information columns corresponding to each lifting size satisfy the following formula: *Zᵢ* × *Kⱼ* ≥ *K*, where *Zᵢ* is an i^{th} number of information columns in the first set of lifting sizes, *Kⱼ* is the j^{th} number of information columns in the sets of numbers of information columns, and K is each length value in the code length interval.

Based on this possible implementation, the lifting size in the first set of lifting sizes can be determined according to the foregoing method, to provide a feasible solution for determining the first set of lifting sizes.

With reference to the first aspect and the second aspect, in a possible implementation, the x^{th} first metric is a difference between the first value and a first product; the x^{th} first metric is a first ratio; or the x^{th} first metric is a difference between 1 and the first ratio, where the first product is a product of the i^{th} lifting size and a second metric, the second metric is determined based on the first value and the i^{th} lifting size, and the first ratio is a ratio of the first product to the first value.

Based on this possible implementation, the x^{th} first metric can be determined based on the foregoing three methods, to provide a plurality of feasible solutions for determining the x^{th} first metric.

With reference to the first aspect and the second aspect, in a possible implementation, the second metric satisfies the following formula: ${δ}_{i} = \left⌊{Z}_{max}/{Z}_{i}\right⌋$, where $\left⌊⋅\right⌋$ represents rounding down.

Based on this possible implementation, the second metric may be understood as a number of blocks that can be decoded in parallel, and the transmitting device or the receiving device may determine the first metric based on the second metric, to ensure that hardware resources are wasted as little as possible during determining of the target lifting size based on the first metric, thereby improving hardware resource utilization, and in particular, improving decoding performance.

With reference to the first aspect and the second aspect, in a possible implementation, when the second metric is greater than a second threshold, the second metric is the second threshold.

Based on this possible implementation, when the second metric is excessively large, complexity of designing a cyclic shift network increases. In this application, the second metric may be limited by using the second threshold, to ensure that the second metric is as small as possible, thereby reducing computational complexity during decoding.

With reference to the first aspect and the second aspect, in a possible implementation, the target lifting size is determined based on a minimum value or a minimum value of the X first metrics; or the target lifting size is determined based on Y first metrics among the X first metrics, where a y^{th} first metric among the Y first metrics is less than or equal to a third threshold corresponding to the y^{th} first metric, or the y^{th} first metric among the Y first metrics is greater than or equal to the third threshold corresponding to the y^{th} first metric; Y is greater than or equal to 1; and y=1, 2, ..., Y.

Based on this possible implementation, the target lifting size is determined based on the minimum value or the maximum value, to ensure that hardware resources are wasted as little as possible, thereby improving hardware resource utilization, and in particular, improving decoding performance. Alternatively, the target lifting size is determined based on the Y first metrics, to provide more feasible solutions for determining the target lifting size. The target lifting size can be determined based on an actual communication status, thereby improving flexibility of determining the target lifting size.

With reference to the first aspect and the second aspect, in a possible implementation, a third threshold corresponding to the x^{th} first metric is determined based on the lifting size corresponding to the x^{th} first metric.

Based on this possible implementation, a feasible solution is provided for determining the third threshold corresponding to the first metric.

With reference to the first aspect and the second aspect, in a possible implementation, the third threshold corresponding to the x^{th} first metric is any one of the following: 1/3Zc, 1/5Zc, 2/5Zc, or 1/4Zc; or the third threshold corresponding to the x^{th} first metric is any one of the following: 1/3, 1/5, 2/5, or 1/4, where Zc is the lifting size corresponding to the x^{th} first metric.

Based on this possible implementation, optional values of the third threshold corresponding to the first metric are provided, to provide more feasible solutions for determining the third threshold corresponding to the first metric. In addition, the third threshold corresponding to the first metric may be determined based on an actual communication status, thereby improving flexibility of determining the third threshold.

With reference to the first aspect and the second aspect, in a possible implementation, when there are at least two minimum values or maximum values, a lifting size with a maximum value or a minimum value in at least two lifting sizes corresponding to the at least two minimum values or maximum values is determined as the target lifting size. Alternatively, when there are at least two minimum values or maximum values, the target lifting size is determined, based on first indication information, from at least two lifting sizes corresponding to the at least two minimum values or maximum values, where the first indication information indicates a communication scenario.

Based on this possible implementation, when there are at least two minimum values or minimum values, the target lifting size can be determined according to the foregoing several methods, and the target lifting size can be determined based on different communication requirements, to provide a plurality of feasible solutions for determining the target lifting size. Further, the target lifting size determined based on the different communication requirements can improve hardware resource utilization, and in particular, can improve decoding performance.

With reference to the first aspect and the second aspect, in a possible implementation, when Y is greater than 1, a lifting size with a maximum value or a minimum value in Y lifting sizes corresponding to the Y first metrics is determined as the target lifting size; or when Y is greater than 1, the target lifting size is determined, based on the first indication information, from the Y lifting sizes corresponding to the Y first metrics, where the first indication information indicates the communication scenario.

Based on this possible implementation, when Y is greater than 1, the target lifting size can be more flexibly determined based on different communication requirements, to provide a plurality of feasible solutions for determining the target lifting size. Further, the target lifting size determined based on the different communication requirements can improve hardware resource utilization, and in particular, can improve decoding performance.

According to a third aspect, a communication method is provided. The method may be performed by a transmitting device. Unless otherwise specified, the "transmitting device" in this application may be the transmitting device, may be a component (for example, a processor, a chip, or a chip system) in the transmitting device, or may be a logical module or software that can implement all or some functions of the transmitting device. The method includes: The transmitting device determines, based on an information bit sequence, sets of numbers of information columns associated with M base graphs corresponding to the information bit sequence and sets of lifting sizes associated with the M base graphs; determines a target lifting size based on the sets of lifting sizes; determines a target number of information columns based on the target lifting size and the sets of numbers of information columns; and determines, from the M base graphs based on the target number of information columns, a base graph corresponding to the target number of information columns, where M is a positive integer greater than or equal to 2, and the base graph is used to encode the information bit sequence to obtain an encoded bit sequence.

According to the foregoing solution, different from determining, by the transmitting device, one base graph based on the information bit sequence, in this application, the M base graphs can be determined based on the information bit sequence, to improve hardware resource utilization during decoding of to-be-decoded information of different lengths. Moreover, the transmitting device determines, from the M base graphs based on the target number of information columns, the base graph used for encoding (for example, when the target number of information columns corresponds to at least two base graphs, the base graph used for encoding may be determined from the M base graphs based on an actual communication scenario), to further improve hardware resource utilization during decoding, and improve decoding performance.

According to a fourth aspect, a communication method is provided. The method may be performed by a receiving device. Unless otherwise specified, the "receiving device" in this application may be the receiving device, may be a component (for example, a processor, a chip, or a chip system) in the receiving device, or may be a logical module or software that can implement all or some functions of the receiving device. The method includes: The receiving device obtains to-be-decoded information from a transmitting device, and determines a length of an information bit sequence corresponding to the to-be-decoded information, sets of numbers of information columns associated with M base graphs corresponding to the information bit sequence, and sets of lifting sizes associated with the M base graphs; and decodes the to-be-decoded information based on a target number of information columns and a target lifting size, to obtain a decoded information bit sequence, where M is a positive integer greater than or equal to 2, and the target number of information columns and the target lifting size are determined based on the sets of numbers of information columns and the sets of lifting sizes.

According to the foregoing solution, different from determining, by the receiving device, one base graph based on the information bit sequence, in this application, the M base graphs can be determined based on the information bit sequence, to improve hardware resource utilization during decoding of to-be-decoded information of different lengths, and further improve decoding performance.

With reference to the third aspect and the fourth aspect, in a possible implementation, the target lifting size is determined by comparing X first metrics, an x^{th} first metric among the X first metrics is determined based on a first value and an i^{th} lifting size in a first set of lifting sizes, the first value is a predefined maximum lifting size, the i^{th} lifting size corresponds to a j^{th} number of information columns in the sets of numbers of information columns, X is greater than or equal to 2, and x=1, 2, ..., X.

Based on this possible implementation, different from determining, by the transmitting device or the receiving device, the target number of information columns based on the length of the information bit sequence, and then determining the target lifting size based on the target number of information columns, in this application, the target lifting size can be determined by comparing the X first metrics. In this way, more feasible solutions can be provided for determining the target lifting size. In addition, it can be ensured that hardware resources are wasted as little as possible during determining of the target lifting size, thereby improving hardware resource utilization, and in particular, improving decoding performance.

With reference to the third aspect and the fourth aspect, in a possible implementation, the i^{th} lifting size is a minimum lifting size that is in the sets of lifting sizes and that supports the j^{th} number of information columns in meeting a fourth condition, where the fourth condition is that a product of the j^{th} number of information columns and a lifting size in the sets of lifting sizes is greater than or equal to the length of the information bit sequence. Alternatively, the j^{th} number of information columns is a minimum number of information columns that is in the sets of numbers of information columns and that supports the i^{th} lifting size in meeting a fifth condition, where the fifth condition is that a product of the i^{th} lifting size and a number of information columns in the sets of numbers of information columns is greater than or equal to the length of the information bit sequence.

Based on this possible implementation, by using the foregoing method, the lifting size corresponding to the j^{th} number of information columns or the number of information columns corresponding to the i^{th} lifting size can be determined, to provide two feasible solutions for determining a correspondence between numbers of information columns and lifting sizes.

With reference to the third aspect and the fourth aspect, in a possible implementation, each lifting size in the first set of lifting sizes and a number of information columns corresponding to each lifting size satisfy the following formula: *Zᵢ* × *Kⱼ* ≥ *K*, where *Zᵢ* is an i^{th} number of information columns in the first set of lifting sizes, *Kⱼ* is the j^{th} number of information columns in the sets of numbers of information columns, and K is the length of the information bit sequence.

Based on this possible implementation, the lifting size in the first set of lifting sizes can be determined according to the foregoing method, to provide a feasible solution for determining the first set of lifting sizes.

With reference to the first aspect and the second aspect, in a possible implementation, the x^{th} first metric is a difference between the first value and a first product; the x^{th} first metric is a first ratio; or the x^{th} first metric is a difference between 1 and the first ratio, where the first product is a product of the i^{th} lifting size and a second metric, the second metric is determined based on the first value and the i^{th} lifting size, and the first ratio is a ratio of the first product to the first value.

Based on this possible implementation, the x^{th} first metric can be determined based on the foregoing three methods, to provide a plurality of feasible solutions for determining the x^{th} first metric.

With reference to the third aspect and the fourth aspect, in a possible implementation, the second metric satisfies the following formula: ${δ}_{i} = \left⌊{Z}_{max}/{Z}_{i}\right⌋$, where $\left⌊⋅\right⌋$ represents rounding down.

Based on this possible implementation, the second metric may be understood as a number of blocks that can be decoded in parallel, and the transmitting device or the receiving device may determine the first metric based on the second metric, to ensure that hardware resources are wasted as little as possible during determining of the target lifting size based on the first metric, thereby improving hardware resource utilization, and in particular, improving decoding performance.

With reference to the third aspect and the fourth aspect, in a possible implementation, when the second metric is greater than a second threshold, the second metric is the second threshold.

Based on this possible implementation, when the second metric is excessively large, complexity of designing a cyclic shift network increases. In this application, the second metric may be limited by using the second threshold, to ensure that the second metric is as small as possible, thereby reducing computational complexity during decoding.

With reference to the third aspect and the fourth aspect, in a possible implementation, the transmitting device or the receiving device determines the target lifting size based on a minimum value or a minimum value of the X first metrics; or the target lifting size is determined based on Y first metrics among the X first metrics, where a y^{th} first metric among the Y first metrics is less than or equal to a third threshold corresponding to the y^{th} first metric, or the y^{th} first metric among the Y first metrics is greater than or equal to the third threshold corresponding to the y^{th} first metric; Y is greater than or equal to 1; and y=1, 2, ..., Y.

Based on this possible implementation, the target lifting size is determined based on the minimum value or the maximum value, to ensure that hardware resources are wasted as little as possible, thereby improving hardware resource utilization, and in particular, improving decoding performance. Alternatively, the target lifting size is determined based on the Y first metrics, to provide more feasible solutions for determining the target lifting size. The target lifting size can be determined based on an actual communication status, thereby improving flexibility of determining the target lifting size.

With reference to the third aspect and the fourth aspect, in a possible implementation, a third threshold corresponding to the x^{th} first metric is determined based on the lifting size corresponding to the x^{th} first metric.

Based on this possible implementation, a feasible solution is provided for determining the third threshold corresponding to the first metric.

With reference to the third aspect and the fourth aspect, in a possible implementation, the third threshold corresponding to the x^{th} first metric is any one of the following: 1/3Zc, 1/5Zc, 2/5Zc, or 1/4Zc; or the third threshold corresponding to the x^{th} first metric is any one of the following: 1/3, 1/5, 2/5, or 1/4, where Zc is the lifting size corresponding to the x^{th} first metric.

Based on this possible implementation, optional values of the third threshold corresponding to the first metric are provided, to provide more feasible solutions for determining the third threshold corresponding to the first metric. In addition, the third threshold corresponding to the first metric may be determined based on an actual communication status, thereby improving flexibility of determining the third threshold.

With reference to the third aspect and the fourth aspect, in a possible implementation, when there are at least two minimum values or maximum values, a lifting size with a maximum value or a minimum value in at least two lifting sizes corresponding to the at least two minimum values or maximum values is determined as the target lifting size. Alternatively, when there are at least two minimum values or maximum values, the target lifting size is determined, based on first indication information, from at least two lifting sizes corresponding to the at least two minimum values or maximum values, where the first indication information indicates a communication scenario.

Based on this possible implementation, when there are at least two minimum values or minimum values, the target lifting size can be determined according to the foregoing several methods, and the target lifting size can be determined based on different communication requirements, to provide a plurality of feasible solutions for determining the target lifting size. Further, the target lifting size determined based on the different communication requirements can improve hardware resource utilization, and in particular, can improve decoding performance.

With reference to the third aspect and the fourth aspect, in a possible implementation, when Y is greater than 1, a lifting size with a maximum value or a minimum value in Y lifting sizes corresponding to the Y first metrics is determined as the target lifting size; or when Y is greater than 1, the target lifting size is determined, based on the first indication information, from the Y lifting sizes corresponding to the Y first metrics, where the first indication information indicates the communication scenario.

Based on this possible implementation, when Y is greater than 1, the target lifting size can be more flexibly determined based on different communication requirements, to provide a plurality of feasible solutions for determining the target lifting size. Further, the target lifting size determined based on the different communication requirements can improve hardware resource utilization, and in particular, can improve decoding performance.

With reference to the first aspect, the second aspect, the third aspect, and the fourth aspect, in a possible implementation, the transmitting device determines a plurality of target information columns from the base graph based on the target number of information columns; and encodes the information bit sequence based on the plurality of target information columns, where the plurality of target information columns include a punctured column of the base graph.

Based on this possible implementation, the transmitting device can determine target information from the base graph based on the target number of information columns, and then encode the information bit sequence based on the target information columns. Different target information columns can be determined for information bit sequences with different lengths, thereby improving decoding performance.

With reference to the first aspect, the second aspect, the third aspect, and the fourth aspect, in a possible implementation, the M base graphs are a nested base graph, and the nested base graph includes information columns of at least two base graphs.

Based on this possible implementation, the nested base graph provides a feasible solution for the plurality of base graphs, so that functions of the plurality of base graphs can be implemented simply. Compared with a plurality of non-nested base graphs, the nested base graph can save storage content and reduce description complexity.

With reference to the first aspect, the second aspect, the third aspect, and the fourth aspect, in a possible implementation, a number of information columns in the set of numbers of information columns satisfies the following formula: u×v, where u is a positive integer, and v is a positive integer.

With reference to the first aspect, the second aspect, the third aspect, and the fourth aspect, in a possible implementation, the set of numbers of information columns is {22, 33, 44}.

Based on the foregoing two possible implementations, a feasible solution is provided for determining the set of numbers of information columns. Different from that the set of numbers of information columns includes 22, in this application, 33 and 44 are further added, and corresponding numbers of information columns can be determined for information bit sequences with different lengths.

With reference to the first aspect, the second aspect, the third aspect, and the fourth aspect, in a possible implementation, a column group structure of one or more base graphs in the M base graphs is column-regular.

Based on this possible implementation, edges in a same column group of a parity-check equation corresponding to the one or more base graphs can be as the same as possible, and a multi-block and multi-packet decoding method can be implemented for the information bit sequence, thereby improving hardware resource utilization, and in particular, improving decoding performance.

With reference to the first aspect, the second aspect, the third aspect, and the fourth aspect, in a possible implementation, a number of groups of one or more base graphs in the M base graphs is greater than or equal to a maximum value of a second metric, where the number of groups of the base graph is a number of variable nodes in a group of variable nodes associated with the base graph, the second metric is determined based on a first value and a c^{th} lifting size in a set of lifting sizes associated with the base graph, and the first value is a predefined maximum lifting size. The c^{th} lifting size is, in the set of lifting sizes associated with the base graph and, a minimum lifting size that supports a d^{th} number of information columns in a set of numbers of information columns associated with the base graph in meeting a first condition, the first condition is that a product of the d^{th} number of information columns and a lifting size in the set of lifting sizes associated with the base graph is greater than or equal to a fourth threshold, the fourth threshold is determined based on the first value and a minimum number of information columns in the set of numbers of information columns associated with the base graph, and c and d are positive integers.

Based on this possible implementation, a feasible solution is provided for determining the number of groups of the base graph, to avoid as much as possible a case in which the number of groups of the base graph is large when the length of the information bit sequence is short, thereby reducing computational complexity of decoding, and improving flexibility of determining the number of groups of the base graph.

With reference to the first aspect, the second aspect, the third aspect, and the fourth aspect, in a possible implementation, the fourth threshold is any one of the following: *K*₃ × *Zₘₐₓ*/2, *K*₃ × *Zₘₐₓ*/3, or *K*₃ × *Zₘₐₓ*/4, where *K*₃ is the minimum number of information columns, and *Zₘₐₓ* is the first value.

Based on this possible implementation, three feasible solutions are provided for determining the fourth threshold.

With reference to the first aspect, the second aspect, the third aspect, and the fourth aspect, in a possible implementation, when sets of numbers of information columns associated with N base graphs among the M base graphs include one number of information columns, a ratio of numbers of information columns associated with the N base graphs is equal to a ratio of numbers of groups associated with the N base graphs, where N is less than or equal to M.

Based on this possible implementation, a feasible solution is provided for determining the numbers of groups of the N base graphs.

With reference to the first aspect, the second aspect, the third aspect, and the fourth aspect, in a possible implementation, a maximum number of information columns in a set of numbers of information columns associated with the base graph is determined based on a first value and a second value, where the first value is a predefined maximum lifting size, and the second value is a maximum value of an information bit sequence length supported by the receiving device; or the maximum number of information columns in the set of numbers of information columns associated with the base graph is determined based on a maximum value of a code rate supported by the base graph, a number of columns in a core parity-check region of the base graph, and a number of punctured columns of the base graph.

Based on this possible implementation, the maximum number of information columns in the set of numbers of information columns associated with the base graph can be determined according to the foregoing two methods, to provide two feasible solutions for determining the maximum number of information columns.

With reference to the first aspect, the second aspect, the third aspect, and the fourth aspect, in a possible implementation, the maximum number of information columns satisfies the following formula: ${K}_{max} \geq z \frac{{K}_{infor}}{{z}_{max}}$; or the maximum number of information columns satisfies the following formula: ${K}_{max} \geq \frac{R \left(C-P\right)}{1 - R}$, where *Kₘₐₓ* is the maximum number of information columns, *K_{infor}* is the second value, *Zₘₐₓ* is the first value, the first value is the predefined maximum lifting size, a value of z is any one of the following: 1, 3/2, 4/3, 5/4, or 2, R is the maximum value of the code rate supported by the base graph, C is a parity-check number of a core region of the base graph, and P is the number of punctured columns of the base graph.

Based on this possible implementation, the transmitting device or the receiving device can explicitly determine the maximum number of information columns based on the foregoing expressions, to provide two feasible solutions for determining the maximum number of information columns.

With reference to the first aspect, the second aspect, the third aspect, and the fourth aspect, in a possible implementation, an interval between two adjacent numbers of information columns in the set of numbers of information columns associated with the base graph is determined based on the minimum number of information columns in the set of numbers of information columns associated with the base graph; the interval between two adjacent numbers of information columns in the set of numbers of information columns associated with the base graph is 1; or the interval between two adjacent numbers of information columns in the set of numbers of information columns associated with the base graph is 2.

Based on this possible implementation, the interval between two adjacent numbers of information columns in the set of numbers of information columns associated with the base graph can be determined based on the minimum number of information columns in the set of numbers of information columns associated with the base graph, so that the interval between two adjacent numbers of information columns is large, thereby reducing design complexity of the base graph. In addition, the interval between two adjacent numbers of information columns may be 1 or 2, so that optional values of the number of information columns can be increased, and corresponding numbers of information columns can be determined for information bit sequences with different lengths, thereby improving decoding performance.

With reference to the first aspect, the second aspect, the third aspect, and the fourth aspect, in a possible implementation, the interval between two adjacent numbers of information columns is any one of the following: $\left⌊\frac{{K}_{3}}{2}\right⌋ , \left⌈\frac{{K}_{3}}{2}\right⌉ , \left⌊\frac{{K}_{3}}{3}\right⌋ , \left⌈\frac{{K}_{3}}{3}\right⌉ , \left⌊\frac{{K}_{3}}{4}\right⌋$, or $\left⌈\frac{{K}_{3}}{4}\right⌉$, where $\left⌊⋅\right⌋$ represents rounding down, $\left⌈⋅\right⌉$ represents rounding up, and *K*₃ is the minimum number of information columns.

Based on this possible implementation, several feasible solutions are provided for the interval between two adjacent numbers of information columns.

With reference to the first aspect, the second aspect, the third aspect, and the fourth aspect, in a possible implementation, an intersection set of sets of numbers of information columns associated with any two of the M base graphs is an empty set; or an intersection set of sets of numbers of information columns associated with at least two base graphs in the M base graphs is not an empty set.

Based on this possible implementation, when the intersection set of the sets of numbers of information columns associated with the any two of the M base graphs is an empty set, the base graph can be directly determined based on the target number of information columns, to reduce computational complexity. When the intersection set of the sets of numbers of information columns associated with the at least two base graphs in the M base graphs is not an empty set, the base graph corresponding to the target number of information columns can be determined by using an additional criterion (for example, a code rate of the information bit sequence, or the first indication information). It can be ensured that the determined base graph is as close as possible to a designed base graph, thereby ensuring stable decoding performance.

According to a fifth aspect, a communication apparatus is provided, and configured to implement the method according to the first aspect. The communication apparatus may be the transmitting device in the first aspect, or an apparatus or a component included in the transmitting device, for example, a chip.

The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In some possible implementations, the communication apparatus may include a processing module and a transceiver module. The transceiver module may include a sending module and a receiving module that are respectively configured to implement a sending function and a receiving function in any one of the first aspect and the possible implementations of the first aspect. The processing module may be configured to implement a processing function in any one of the first aspect and the possible implementations of the first aspect. For example, the processing module is configured to determine, based on an information bit sequence, sets of numbers of information columns associated with M base graphs corresponding to the information bit sequence and sets of lifting sizes associated with the M base graphs, where M is a positive integer greater than or equal to 2. The processing module is further configured to determine, based on first information, a number of information columns associated with a code length interval corresponding to a length of the information bit sequence as a target number of information columns, where the first information indicates a number of information columns associated with each of a plurality of code length intervals, and the number of information columns associated with the code length interval is determined based on the sets of numbers of information columns and/or the sets of lifting sizes. The processing module is further configured to determine, from the M base graphs based on the target number of information columns, a base graph corresponding to the target number of information columns, where the base graph is used to encode the information bit sequence to obtain an encoded bit sequence.

Optionally, the transceiver module and the processing module of the communication apparatus in the fifth aspect may further perform corresponding functions in any one of the first aspect or the possible implementations of the first aspect. For details, refer to the detailed descriptions in the method examples. For beneficial effects that can be achieved, refer to the foregoing related content.

According to a sixth aspect, a communication apparatus is provided, and configured to implement the method according to the second aspect. The communication apparatus may be the receiving device in the second aspect, or an apparatus or a component included in the receiving device, for example, a chip.

The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In some possible implementations, the communication apparatus may include a processing module and a transceiver module. The transceiver module may include a sending module and a receiving module that are respectively configured to implement a sending function and a receiving function in any one of the second aspect and the possible implementations of the second aspect. The processing module may be configured to implement a processing function in any one of the second aspect and the possible implementations of the second aspect. For example, the transceiver module is configured to obtain to-be-decoded information from a transmitting device. The processing module is configured to determine a length of an information bit sequence corresponding to the to-be-decoded information, sets of numbers of information columns associated with M base graphs corresponding to the information bit sequence, and sets of lifting sizes associated with the M base graphs, where M is greater than or equal to 2. The processing module is configured to determine, based on first information and the length of the information bit sequence, a number of information columns associated with a code length interval corresponding to the length of the information bit sequence as a target number of information columns, where the first information indicates a number of information columns associated with each of a plurality of code length intervals, and the number of information columns associated with the code length interval is determined based on the sets of numbers of information columns and/or the sets of lifting sizes. The processing module is further configured to decode the to-be-decoded information based on the target number of information columns and a lifting size, to obtain a decoded information bit sequence, where a target lifting size is determined based on the sets of lifting sizes.

Optionally, the transceiver module and the processing module of the communication apparatus in the sixth aspect may further perform corresponding functions in any one of the second aspect or the possible implementations of the second aspect. For details, refer to the detailed descriptions in the method examples. For beneficial effects that can be achieved, refer to the foregoing related content.

According to a seventh aspect, a communication apparatus is provided, and configured to implement the method according to the third aspect. The communication apparatus may be the transmitting device in the third aspect, or an apparatus or a component included in the transmitting device, for example, a chip.

The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In some possible implementations, the communication apparatus may include a processing module and a transceiver module. The transceiver module may include a sending module and a receiving module that are respectively configured to implement a sending function and a receiving function in any one of the third aspect and the possible implementations of the third aspect. The processing module may be configured to implement a processing function in any one of the third aspect and the possible implementations of the third aspect. For example, the processing module is configured to determine, based on an information bit sequence, sets of numbers of information columns associated with M base graphs corresponding to the information bit sequence and sets of lifting sizes associated with the M base graphs, where M is a positive integer greater than or equal to 2. The processing module is further configured to determine a target lifting size based on the sets of lifting sizes. The processing module is further configured to determine a target number of information columns based on the target lifting size and the sets of numbers of information columns. The processing module is further configured to determine, from the M base graphs based on the target number of information columns, a base graph corresponding to the target number of information columns, where the base graph is used to encode the information bit sequence to obtain an encoded bit sequence.

Optionally, the transceiver module and the processing module of the communication apparatus in the seventh aspect may further perform corresponding functions in any one of the third aspect or the possible implementations of the third aspect. For details, refer to the detailed descriptions in the method examples. For beneficial effects that can be achieved, refer to the foregoing related content.

According to an eighth aspect, a communication apparatus is provided, and configured to implement the method according to the fourth aspect. The communication apparatus may be the receiving device in the fourth aspect, or an apparatus or a component included in the receiving device, for example, a chip.

The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In some possible implementations, the communication apparatus may include a processing module and a transceiver module. The transceiver module may include a sending module and a receiving module that are respectively configured to implement a sending function and a receiving function in any one of the fourth aspect and the possible implementations of the fourth aspect. The processing module may be configured to implement a processing function in any one of the fourth aspect and the possible implementations of the fourth aspect. For example, the transceiver module is configured to obtain to-be-decoded information from a transmitting device. The processing module is configured to determine a length of an information bit sequence corresponding to the to-be-decoded information, sets of numbers of information columns associated with M base graphs corresponding to the information bit sequence, and sets of lifting sizes associated with the M base graphs, where M is a positive integer greater than or equal to 2. The processing module is further configured to decode the to-be-decoded information based on a target number of information columns and a target lifting size, to obtain a decoded information bit sequence, where the target number of information columns and the target lifting size are determined based on the sets of numbers of information columns and the sets of lifting sizes.

Optionally, the transceiver module and the processing module of the communication apparatus in the eighth aspect may further perform corresponding functions in any one of the fourth aspect or the possible implementations of the fourth aspect. For details, refer to the detailed descriptions in the method examples. For beneficial effects that can be achieved, refer to the foregoing related content.

According to a ninth aspect, a communication apparatus is provided, including at least one processor. The processor is configured to cause, by executing computer instructions stored in a memory or by using a logic circuit, the communication apparatus to perform the method according to any one of the foregoing aspects or the possible implementations of the foregoing aspects. The communication apparatus may be the transmitting device in any one of the first aspect or the possible implementations of the first aspect, or an apparatus or a component included in the transmitting device, for example, a chip; the communication apparatus may be the receiving device in any one of the second aspect or the possible implementations of the second aspect, or an apparatus or a component included in the receiving device, for example, a chip; the communication apparatus may be the transmitting device in any one of the third aspect or the possible implementations of the third aspect, or an apparatus or a component included in the transmitting device, for example, a chip; or the communication apparatus may be the receiving device in any one of the fourth aspect or the possible implementations of the fourth aspect, or an apparatus or a component included in the receiving device, for example, a chip.

In some possible implementations, the communication apparatus further includes the memory configured to store the computer instructions and/or a configuration file of the logic circuit. Optionally, the memory is integrated with the processor, or the memory is independent of the processor.

According to a tenth aspect, a communication apparatus is provided, including a processor and a communication interface. The communication interface is configured to input and/or output a signal. The processor is configured to execute a computer program or instructions, to cause the communication apparatus to perform the method according to any one of the foregoing aspects. The communication apparatus may be the transmitting device in any one of the first aspect or the possible implementations of the first aspect, or an apparatus or a component included in the transmitting device, for example, a chip; the communication apparatus may be the receiving device in any one of the second aspect or the possible implementations of the second aspect, or an apparatus or a component included in the receiving device, for example, a chip; the communication apparatus may be the transmitting device in any one of the third aspect or the possible implementations of the third aspect, or an apparatus or a component included in the transmitting device, for example, a chip; or the communication apparatus may be the receiving device in any one of the fourth aspect or the possible implementations of the fourth aspect, or an apparatus or a component included in the receiving device, for example, a chip.

In some possible implementations, the communication interface is an interface circuit, and is configured to read and write computer instructions. For example, the interface circuit is configured to receive computer-executable instructions (the computer-executable instructions are stored in a memory, and may be directly read from the memory, or may be read via another component), and transmit the computer-executable instructions to the processor.

In some possible implementations, the communication interface is configured to communicate with a module outside the communication apparatus.

In some possible implementations, the communication apparatus may be a chip or a chip system. When the apparatus is the chip system, the chip system may include a chip, or may include a chip and another discrete component.

According to an eleventh aspect, a communication apparatus is provided, including a logic circuit and an interface circuit. The interface circuit is configured to input information and/or output information. The logic circuit is configured to perform the method according to any one of the foregoing aspects, and perform processing and/or generate to-be-output information based on the input information. The communication apparatus may be the transmitting device in any one of the first aspect or the possible implementations of the first aspect, or an apparatus or a component included in the transmitting device, for example, a chip; the communication apparatus may be the receiving device in any one of the third aspect or the possible implementations of the third aspect, or an apparatus or a component included in the receiving device, for example, a chip; the communication apparatus may be the transmitting device in any one of the fourth aspect or the possible implementations of the fourth aspect, or an apparatus or a component included in the transmitting device, for example, a chip; or the communication apparatus may be the receiving device in any one of the second aspect or the possible implementations of the second aspect, or an apparatus or a component included in the receiving device, for example, a chip.

According to a twelfth aspect, a computer-readable storage medium is provided. The computer-readable storage medium stores a computer program or instructions. When the computer program or the instructions are executed by a processor, the method according to any one of the foregoing aspects is performed.

According to a thirteenth aspect, a computer program product is provided. When the computer program product is executed by a processor, the method according to any one of the foregoing aspects is performed.

It may be understood that when the communication apparatus provided in any one of the fifth aspect to the eleventh aspect is a chip, the foregoing sending action/function may be understood as outputting information, and the foregoing receiving action/function may be understood as inputting information.

For technical effects brought by any one of implementations of the fifth aspect to the thirteenth aspect, refer to the technical effects brought by any one of the first aspect or the possible implementations of the first aspect, the technical effects brought by any one of the second aspect or the possible implementations of the second aspect, the technical effects brought by any one of the third aspect or the possible implementations of the third aspect, or the technical effects brought by any one of the fourth aspect or the possible implementations of the fourth aspect. Details are not described herein again.

According to a fourteenth aspect, a communication system is provided. The communication system includes the transmitting device according to any one of the first aspect or the possible implementations of the first aspect and the receiving device according to any one of the second aspect or the possible implementations of the second aspect; or the system includes the transmitting device according to any one of the third aspect or the possible implementations of the third aspect and the receiving device according to any one of the fourth aspect or the possible implementations of the fourth aspect.

### BRIEF DESCRIPTION OF DRAWINGS

FIG. 1 is a diagram of information transmission according to an embodiment of this application;
FIG. 2 is a diagram of a base matrix structure according to an embodiment of this application;
FIG. 3 is a diagram of a base matrix structure according to an embodiment of this application;
FIG. 4a and FIG. 4b are diagrams of decoding performance according to an embodiment of this application;
FIG. 5 is a diagram of a communication system according to an embodiment of this application;
FIG. 6 is a diagram of a communication system according to an embodiment of this application;
FIG. 7 is a diagram of a structure of a communication apparatus according to an embodiment of this application;
FIG. 8 is a diagram of interaction of a communication method according to an embodiment of this application;
FIG. 9 is a diagram of a nested base graph according to an embodiment of this application;
FIG. 10 is a diagram of interaction of a communication method according to an embodiment of this application;
FIG. 11 is a diagram of interaction of a communication method according to an embodiment of this application;
FIG. 12 is a diagram of a column group structure of a base graph according to an embodiment of this application;
FIG. 13 is a diagram of simulation of a relationship between a wasted degree of parallelism and information bit sequences with different lengths according to an embodiment of this application;
FIG. 14 is a diagram of simulation of numbers of information columns corresponding to information bit sequences with different lengths according to an embodiment of this application;
FIG. 15 is a diagram of simulation of a relationship between a wasted degree of parallelism and information bit sequences with different lengths according to an embodiment of this application;
FIG. 16 is a diagram of simulation of numbers of information columns corresponding to information bit sequences with different lengths according to an embodiment of this application;
FIG. 17 is a diagram of simulation of gains corresponding to different numbers of information columns according to an embodiment of this application;
FIG. 18 is a diagram of simulation of gains corresponding to different numbers of information columns according to an embodiment of this application;
FIG. 19 is a diagram of simulation of gains corresponding to different numbers of information columns according to an embodiment of this application;
FIG. 20 is a diagram of a structure of a transmitting device according to an embodiment of this application;
FIG. 21 is a diagram of a structure of a receiving device according to an embodiment of this application; and
FIG. 22 is a diagram of a structure of another communication apparatus according to an embodiment of this application.

### DESCRIPTION OF EMBODIMENTS

The following describes implementations of embodiments of this application in detail with reference to the accompanying drawings in this specification.

In descriptions of this application, unless otherwise specified, "/" represents an "or" relationship between associated objects. For example, A/B may represent A or B. In this application, "and/or" describes only an association relationship between associated objects, and represents that three relationships may exist. For example, A and/or B may represent the following three cases: Only A exists, both A and B exist, and only B exists, where A and B may be singular or plural.

In addition, in the descriptions of this application, "a plurality of" means two or more than two unless otherwise specified. "At least one of the following items (pieces)" or a similar expression thereof refers to any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural.

In addition, to clearly describe technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

It may be understood that, an "embodiment" mentioned throughout this specification means that particular features, structures, or characteristics related to this embodiment are included in at least one embodiment of this application. Therefore, embodiments in the entire specification are not necessarily a same embodiment. In addition, these particular features, structures, or characteristics may be combined in one or more embodiments by using any appropriate manner. It may be understood that sequence numbers of the processes do not mean execution sequences in various embodiments of this application. The execution sequences of the processes should be determined based on functions and internal logic of the processes, and should not be construed as any limitation on implementation processes of embodiments of this application.

It may be understood that in some scenarios, some optional features in embodiments of this application may be independently implemented without depending on another feature, for example, a solution on which the optional features are currently based, to resolve a corresponding technical problem and achieve corresponding effects. Alternatively, in some scenarios, the optional features may be combined with other features based on a requirement. Correspondingly, the apparatus provided in embodiments of this application may also correspondingly implement these features or functions. Details are not described herein.

In this application, unless otherwise specified, for same or similar parts of embodiments, mutual reference may be made between the embodiments. In embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment. The following implementations of this application are not intended to limit the protection scope of this application.

For ease of understanding of the technical solutions in embodiments of this application, the following first briefly describes technologies related to this application.

### (1) Signal transmission

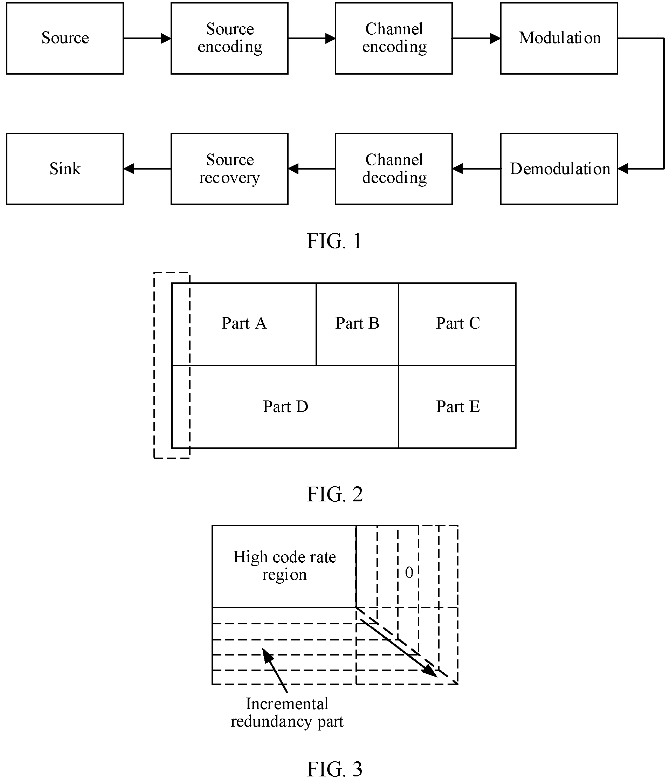

In communication systems, as shown in FIG. 1, information sent by a source may undergo source encoding, channel encoding, modulation, and the like, to form a signal. After the signal is transmitted through a channel, a sink receives the signal, and the signal undergoes demodulation, channel decoding, source recovery, and the like to become the information. In this way, signal transmission between the sink and the source is implemented.

Main types of channel codes include linear block codes, convolutional codes, concatenated codes, LDPC codes, and the like.

### (2) LDPC code

The LDPC codes, which are an abbreviation of low-density parity-check codes, are a type of channel encoding scheme that rigorously achieve the Shannon limit, offering characteristics like good coding performance and low complexity. The LDPC codes have been adopted by the 3rd generation partnership project protocol (3rd generation partnership project, 3GPP) as a channel encoding scheme for 5th generation (5th generation, 5G) mobile communication systems.

With the LDPC codes, channel encoding can be implemented by using a generator matrix or a parity-check matrix. In mainstream applications, the LDPC codes use a quasi-cyclic (quasi-cyclic, QC) structure. In other words, setting a shifting value of each block can maximally avoid short cycles and other detrimental structures, and can further increase a code distance.

### (3) LDPC code decoding algorithm

Optionally, LDPC code decoding algorithms may be a minimum sum (min-sum, MS) decoding algorithm and a belief propagation (belief propagation, BP) decoding algorithm.

The BP decoding algorithm has good decoding performance, but requires a large amount of information storage and has high computational complexity, which is not conducive to hardware implementation.

The MS decoding algorithm has poor decoding performance, but has low computational complexity and is easier to implement in hardware. In an actual communication system, an offset-MS (Offset-MS) decoding algorithm and a normalized MS (Normalized MS) decoding algorithm are usually used.

### (4) Base graph

A base graph model of a QC-LDPC code may be represented as *BG* = (*X*, *Y*, *F*), where *X* is a corresponding variable, *Y* is a parity-check equation associated with the corresponding variable, and *F* is an edge relationship between the corresponding variable and the parity-check equation associated with the corresponding variable.

Optionally, a base graph of the QC-LDPC code may be expanded to a circulant permutation matrix. In other words, after QC expansion with a lifting size of Z, the base graph of the QC-LDPC code yields a Tanner (Tanner) graph (the Tanner graph is in one-to-one correspondence with a parity-check matrix).

The Tanner graph may be represented as: *G* = (*V*, *C*, *E*), where *V* is a variable node, *C* is a check node, and *E* is an edge relationship between the variable node and the check node.

Optionally, based on the Tanner graph and the lifting size Z, it may be determined that a number of columns of the parity-check matrix is |*V*| = Z|*X*|, and a number of non-zero elements of the parity-check matrix is |*E*| = *Z*|*F*|.

In 5G mobile communication systems, information bit sequence lengths that can be supported by data channels range from 1 to 8448 bits. Information bit sequences with different lengths correspond to different base graphs (for example, a base graph 1 (BG 1) and a base graph 2 (BG 2)), and a same base graph may adapt to rate matching of information bit sequences with different lengths by using different lifting sizes.

The base graph 1 and the base graph 2 have a common base matrix structure. As shown in FIG. 2, a part A is an information column region with a high code rate, a part B is a core parity-check region with a high code rate, a part C is a zero matrix, a part D is an incremental redundancy region of a base matrix and corresponds to a low code rate matrix, and a part E is an incremental redundancy region and is of a unit matrix structure.

A value of the base matrix is 0 or 1. The value 0 indicates an empty element. The value 1 indicates an edge of the base graph, or the value 1 indicates that a corresponding check is associated with a corresponding variable.

A region in a dashed box in FIG. 2 is a punctured column, the first two columns of the base matrix are punctured columns, and a column weight (the column weight is a number of 1s in the column) of the punctured column is large. In a transmission process, the punctured column does not participate in transmission, but the punctured column participates in encoding and decoding.

It may be understood that the base matrix is designed based on a minimum code rate (that is, encoding of an information bit sequence at the minimum code rate can be implemented). When the code rate changes, an upper left part of the base matrix may be extracted for encoding.

For example, as shown in FIG. 3, the part A and the part B can implement encoding of an information bit sequence at a maximum code rate.

For example, a peak throughput scenario (a code length of an information bit sequence is 1k to 2k bits or greater than 8k bits) of the 5G mobile communication system is used as an example. In this scenario, encoding of the information bit sequence may be implemented by using the base graph 1. A number of information columns of the part A corresponding to the base graph 1 is 22, a number of information columns of the part B is 4, and a number of punctured columns is 2. In this case, a code rate supported by the base graph 1 is 22/(22+4-2)=11/12≈0.917.

It may be understood that an information bit sequence whose code rate is greater than 0.917 may be encoded by using an additional punctured column.

Optionally, a transmitting device may determine a base graph based on a length of an information bit sequence, determine a number of information columns based on the base graph, and further determine information columns of an LDCP matrix based on the number of information columns.

For example, information columns of LDPC code matrices corresponding to information bit sequences with different lengths may be determined according to a 5G communication protocol. When the length of the information bit sequence is less than or equal to 192 bits, it may be determined that the information columns of the LDPC code matrix are columns 1 to 6 of the BG 2. When the length of the information bit sequence is greater than 192 bits and less than or equal to 560 bits, it may be determined that the information columns of the LDPC code matrix are columns 1 to 8 of the BG 2. When the length of the information bit sequence is greater than 560 bits and less than or equal to 640 bits, it may be determined that the information columns of the LDPC code matrix are columns 1 to 9 of the BG 2. When the length of the information bit sequence is greater than 640 bits, it may be determined that the information columns of the LDPC code matrix are columns 1 to 10 of the BG 2.

### (5) Multi-block and multi-packet decoding method

A receiving device may decode information bit sequences with different lengths, and design decoding performance of the receiving device based on a highest parallelism degree (namely, a maximum value of a lifting size, for example, the maximum value of the lifting size may be 384). When the lifting size is less than a maximum value of a lifting size supported by the receiving device, the receiving device may perform parallel decoding by using a multi-block and multi-packet method, to improve hardware resource utilization during decoding as much as possible.

The transmitting device or the receiving device may determine a number of information columns of a base graph based on a length of the information bit sequence, and then determine a lifting size based on the number of information columns of the base graph.

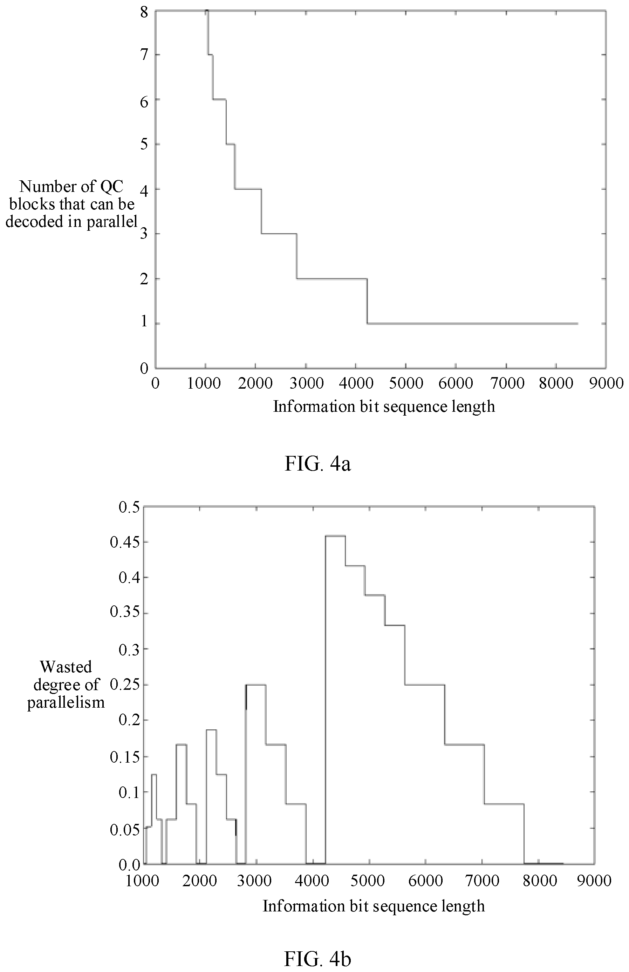

However, as shown in FIG. 4a and FIG. 4b, when decoding is performed according to the foregoing multi-block and multi-packet decoding method, there are always information bit sequences with some lengths have a high wasted degree of parallelism (that is, hardware resource utilization is low). As a result, there are a large number of idle hardware resources, and a substantial waste of chips is caused.

It can be learned from FIG. 4a that a horizontal axis represents an information bit sequence length, and a vertical axis represents a number of QC blocks that can be decoded in parallel. As the information bit sequence length increases, the number of QC blocks that can be decoded in parallel decreases gradually. It can be learned from FIG. 4b that a horizontal axis represents an information bit sequence length, and a vertical axis represents a wasted degree of parallelism. When the information bit sequence length is slightly greater than half of a maximum value of an information bit sequence length supported by an LDPC code, the wasted degree of parallelism is close to 50% (that is, the hardware resource utilization is slightly higher than 50%). When the information bit sequence length is greater than half of a maximum value of the information bit sequence supported by the LDPC code, the wasted degree of parallelism is still excessively high, causing a waste of hardware resources.

Future mobile communication systems (for example, 6G) may achieve a throughput of 200 Gbit/s (Gbps) or even higher. In addition, an information bit sequence length/size supported by the future mobile communication systems may be relatively large. Therefore, the industry has high expectations for hardware resource utilization of communication devices. It is found by the inventor that, by using, for example, the foregoing encoding and decoding methods, a waste of hardware resources will occur more widely.

In conclusion, how to improve hardware resource utilization, and in particular, improve decoding performance, becomes an urgent problem to be resolved.

Therefore, this application provides a communication method. The method includes: The transmitting device determines, based on an information bit sequence, sets of numbers of information columns associated with M base graphs corresponding to the information bit sequence and sets of lifting sizes associated with the M base graphs; determines, based on first information, a number of information columns associated with a code length interval corresponding to a length of the information bit sequence as a target number of information columns; and determines, from the M base graphs based on the target number of information columns, a base graph corresponding to the target number of information columns, where M is a positive integer greater than or equal to 2, the first information indicates a number of information columns associated with each of a plurality of code length intervals, and the base graph is used to encode the information bit sequence to obtain an encoded bit sequence.

Optionally, the number of information columns associated with the code length interval is determined based on the sets of numbers of information columns and/or the sets of lifting sizes.

In embodiments of this application, the transmitting device may determine the code length interval corresponding to the length of the information bit sequence, to explicitly determine, based on the first information, the number of information columns associated with the code length interval as the target number of information columns, thereby reducing computational complexity, and improving working efficiency of the transmitting device. In addition, different from determining, by the transmitting device, one base graph based on the information bit sequence, in this application, the M base graphs can be determined based on the information bit sequence. The M base graphs correspond to different numbers of information columns. The base graphs corresponding to the different numbers of information columns can reduce an overlapping peak area of a waste of resources, to greatly reduce a proportion of idle hardware resources, and further improve hardware resource utilization during decoding of to-be-decoded information of different lengths. Moreover, the transmitting device determines, from the M base graphs based on the target number of information columns, the base graph used for encoding (for example, when the target number of information columns corresponds to at least two base graphs, the base graph used for encoding may be determined from the M base graphs based on an actual communication scenario), to further improve hardware resource utilization, and improve decoding performance.

The technical solutions in embodiments of this application may be applied to various communication systems. The communication system may be a 3GPP communication system, for example, 4th generation (4th generation, 4G), long term evolution (long term evolution, LTE), a 5G mobile communication system, new radio/new radio (New Radio, NR), a system with LTE-5G hybrid networking, a non-terrestrial communication network (non-terrestrial network, NTN) system, a future communication system (for example, a 6th generation (sixth generation, 6G) mobile communication system), a vehicle-to-everything (vehicle-to-everything, V2X) system, a device-to-device (device-to-device, D2D) communication system, a machine-to-machine (machine-to-machine, M2M) communication system, an internet of things (Internet of Things, IoT), a narrowband-internet of things (Narrowband-internet of things, NB-IoT), another future communication system, an integrated sensing and communication system, a satellite communication system, or the like. The communication system may alternatively be a non-3GPP communication system, for example, a wireless local area network (wireless local area network, WLAN) system like wireless fidelity (wireless fidelity, Wi-Fi).

The technical solutions in embodiments of this application may be applied to various communication scenarios, for example, sensing, downlink synchronization, and channel estimation scenarios.

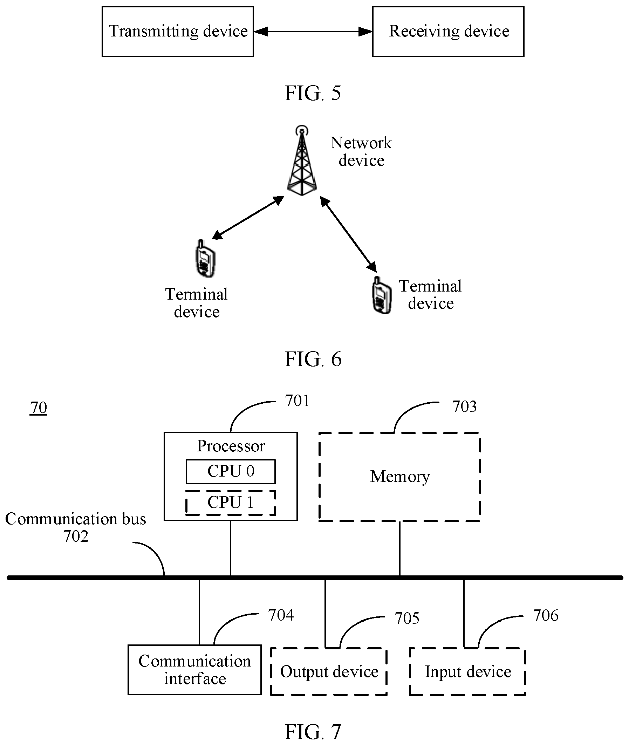

For example, FIG. 5 is a diagram of a structure of a communication system according to this application. The communication system may include a transmitting device and a receiving device.

The communication system can complete a specific function, for example, synchronization, channel estimation, or sensing.

It should be noted that, unless otherwise specified, the "transmitting device" in this application may be the transmitting device, or may be a component (for example, a processor, a chip, or a chip system) in the transmitting device, or may be a logical module or software that can implement all or some functions of the transmitting device.

It should be noted that, unless otherwise specified, the "receiving device" in this application may be the receiving device, or may be a component (for example, a processor, a chip, or a chip system) in the receiving device, or may be a logical module or software that can implement all or some functions of the receiving device.

The transmitting device may be a terminal device, or may be a network device. This is not limited.

The receiving device may be a terminal device, or may be a network device. This is not limited.

As shown in FIG. 6, a terminal device in embodiments of this application may be within beam/cell coverage of a network device, and the network device may provide a communication service for the terminal device.

The terminal device in FIG. 6 may be a device having a wireless transceiver function or a chip or a chip system that can be disposed in the device, may allow a user to access a network, and is a device configured to provide voice and/or data connectivity for the user. The terminal device may also be referred to as user equipment (user equipment, UE), a subscriber unit (subscriber unit), a terminal (terminal), a mobile station (mobile station, MS), a mobile terminal (mobile terminal, MT), or the like.

Optionally, the terminal device in embodiments of this application may be a user-side device configured to implement a wireless communication function, for example, a terminal or a chip that may be used in the terminal. The terminal may be UE, an access terminal, a terminal unit, a terminal station, a mobile station, a remote station, a remote terminal, a mobile device, a wireless communication device, a terminal agent, a terminal apparatus, or the like in a 5G network or a public land mobile network (public land mobile network, PLMN) evolved from 5G. The access terminal may be a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a compute device or another processing device connected to a wireless modem, a vehicle-mounted device, an uncrewed aerial vehicle, a robot, a smart point of sale (point of sale, POS) machine, customer-premises equipment (customer-premises equipment, CPE) or a wearable device, a virtual reality (virtual reality, VR) terminal device, an augmented reality (augmented reality, AR) terminal device, a wireless terminal in industrial control (industrial control), a wireless terminal in self-driving (self-driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), or the like. Alternatively, the terminal may be a terminal having a communication function in the IoT, for example, a terminal in V2X (for example, a vehicle to everything device), a terminal in D2D communication, or a terminal in M2M communication. The terminal may be mobile or fixed.

The network device in FIG. 6 may be any device that is deployed in an access network and that can perform wireless communication with a terminal device, or may be a chip or a chip system that can be disposed in the device, or may be a logical node or a logical module or a function implemented by software, and may be configured to implement functions such as a radio physical control function, resource scheduling and radio resource management, radio access control, and mobility management. Specifically, the network device may be a device supporting wired access, or may be a device supporting wireless access.

Optionally, the network device in embodiments of this application is a device that connects a terminal device to a wireless network. The network device may be a node in a radio access network (radio access network, RAN), or may be a base station, and may be referred to as a radio access network node (or device).

For example, the network device may include an evolved NodeB (NodeB or eNB or e-NodeB, evolutional NodeB) in an LTE system or an LTE-advanced (LTE-advanced, LTE-A) system, for example, a conventional macro base station eNB and a micro base station eNB in a heterogeneous network scenario. Alternatively, the network device may include a next generation NodeB (next generation NodeB, gNB) in an NR system. Alternatively, the network device may include a transmission reception point (transmission reception point, TRP), a home base station (for example, a home evolved NodeB or a home NodeB, HNB), a baseband unit (baseband unit, BBU), a baseband unit pool (BBU pool), a Wi-Fi access point (access point, AP), or the like. Alternatively, the network device may include a base station in an NTN, to be specific, may be deployed on a flying platform or a satellite. In the NTN, the network device may serve as a layer 1 (L1) relay (relay), may serve as a base station, or may serve as an integrated access and backhaul (integrated access and backhaul, IAB) node. Alternatively, the network device may be a device that is in an IoT and that implements functions of a base station, for example, a device that is in uncrewed aerial vehicle communication, V2X, D2D, or machine-to-machine (machine-to-machine, M2M) and that implements the functions of the base station.

Alternatively, the network device may be a module or unit that can implement some functions of the base station. For example, the network device may be a central unit (central unit, CU), a distributed unit (distributed unit, DU), a CU-control plane (control plane, CP), a CU-user plane (user plane, UP), or a radio unit (radio unit, RU). The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may alternatively have different names, but a person skilled in the art may understand meanings thereof. For example, the network device may be a network device in an open radio access network (open RAN, ORAN) system or a module of the network device. In the ORAN system, the CU may also be referred to as an open (open, O)-CU, the DU may also be referred to as an O-DU, the CU-CP may also be referred to as an O-CU-CP, the CU-UP may also be referred to as an O-CU-UP, and the RU may also be referred to as an O-RU. Any one of the CU (or the CU-CP or the CU-UP), the DU, and the RU in this application may be implemented by using a software module, a hardware module, or a combination of a software module and a hardware module.

Optionally, the base station in embodiments of this application may include various forms of base stations, for example, a macro base station, a micro base station (also referred to as a small cell), a relay station, an access point, a home base station, a TRP, a transmitting point (transmitting point, TP), or a mobile switching center. This is not specifically limited in embodiments of this application.

It should be noted that the communication system described in embodiments of this application is intended to describe the technical solutions in embodiments of this application more clearly, but constitutes no limitation on the technical solutions provided in embodiments of this application. A person of ordinary skill in the art may learn that the technical solutions provided in embodiments of this application are also applicable to a similar technical problem as a network architecture evolves and a new service scenario emerges.

For example, the new service scenario may be a high throughput scenario, an ultra-reliable low-latency communications (ultra-reliable low-latency communications, URLLC) scenario, and a low-power-consumption scenario.

The scenario may be distinguished by using a code length and a code rate of an information bit sequence, or the scenario may be specified in a standard. This is not limited.

For example, the high throughput scenario is a scenario in which a code rate is high (for example, the code rate is greater than or equal to 0.926, 0.917, or 5/6) and a length of an information bit sequence is long (for example, the length of the information bit sequence is 8k to 16k bits).

For another example, the URLLC scenario is a scenario in which a code rate is low (for example, the code rate is less than or equal to 1/3, 2/5, 1/5, or 1/6) and a code length of an information bit sequence is short-to-medium (for example, the code length of the information bit sequence is less than or equal to 2k bits).

During specific implementation, the transmitting device or the receiving device shown in FIG. 5 may use a composition structure shown in FIG. 7, or include components shown in FIG. 7. FIG. 7 is a composition diagram of a communication apparatus 70 according to an embodiment of this application. The communication apparatus 70 may be a transmitting device, or a chip or a system-on-chip in the transmitting device; or may be a receiving device, or a chip or a system-on-chip in the receiving device.

As shown in FIG. 7, the communication apparatus 70 includes one or more processors 701. Further, the communication apparatus 70 may further include a communication bus 702 and at least one communication interface (FIG. 7 is merely an example, and an example in which the communication apparatus 70 includes a communication interface 704 and one processor 701 is used for description). Optionally, the communication apparatus 70 may further include a memory 703.

The processor 701 may be a general-purpose central processing unit (central processing unit, CPU), a microprocessor, an application-specific integrated circuit (application-specific integrated circuit, ASIC), one or more integrated circuits configured to control program execution in the solutions of this application, or a processing core configured to process data (for example, computer program instructions). The processor may be a single-core (single-CPU) processor, or may be a multi-core (multi-CPU) processor.

During specific implementation, in an embodiment, the processor 701 may include one or more CPUs such as a CPU 0 and a CPU 1 in FIG. 7.

The communication bus 702 may be a peripheral component interconnect (peripheral component interconnect, PCI) bus, an extended industry standard architecture (extended industry standard architecture, EISA) bus, or the like. The bus may be classified into an address bus, a data bus, a control bus, and the like. For ease of representation, only one bold line is used for representation in FIG. 7, but this does not mean that there is only one bus or only one type of bus. The communication bus 702 is configured to connect different components in the communication apparatus 70, so that the different components in the communication apparatus 70 may communicate and interact with each other.

The communication interface 704 may be a transceiver module configured to communicate with another device or a communication network. The communication network may be, for example, an ethernet (Ethernet), a radio access network (radio access network, RAN), or a wireless local area network (wireless local area network, WLAN). For example, the communication interface 704 may be an apparatus, for example, a transceiver or a transceiver machine. Alternatively, the communication interface 704 may be a transceiver circuit in the processor 701, to implement signal input and signal output of the processor.

The memory 703 may be an apparatus having a storage function. For example, the memory may be a read-only memory (read-only memory, ROM) or another type of static storage device that can store static information and instructions, or a random access memory (random access memory, RAM) or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another optical disc storage, an optical disc storage (including a compact optical disc, a laser disc, an optical disc, a digital versatile optical disc, a blue optical disc, and the like), a magnetic disk storage medium or another magnetic storage device, or any other medium that can carry or store expected program code in an instruction or data structure form and can be accessed by a computer, but is not limited thereto. The memory may exist independently, and is connected to the processor through the communication bus 702. The memory may alternatively be integrated with the processor.

For example, the memory 703 is configured to store computer-executable instructions for executing the solutions of this application, and the processor 701 controls the execution. The processor 701 is configured to execute the computer-executable instructions stored in the memory 703, to implement the method provided in embodiments of this application.

Alternatively, optionally, in this embodiment of this application, the processor 701 may perform a processing-related function in the method provided in the following embodiments of this application, and the communication interface 704 is responsible for communicating with another device or a communication network. This is not specifically limited in embodiments of this application.

Optionally, the computer-executable instructions in this embodiment of this application may also be referred to as application program code. This is not specifically limited in this embodiment of this application.

During specific implementation, in an embodiment, the communication apparatus 70 may further include an output device 705 and an input device 706. The output device 705 communicates with the processor 701, and may display information in a plurality of manners. For example, the output device 705 may be a liquid crystal display (liquid crystal display, LCD), a light emitting diode (light emitting diode, LED) display device, a cathode ray tube (cathode ray tube, CRT) display device, or a projector (projector). The input device 706 communicates with the processor 701, and may receive an input from a user in a plurality of manners. For example, the input device 706 may be a mouse, a keyboard, a touchscreen device, or a sensing device.

It should be noted that the composition structure shown in FIG. 7 does not constitute a limitation on the communication apparatus. In addition to the components shown in FIG. 7, the communication apparatus may include more or fewer components than those shown in the figure, or some components may be combined, or different component arrangements may be used.

The following describes the communication method provided in embodiments of this application with reference to the accompanying drawings. It may be understood that in embodiments of this application, the transmitting device or the receiving device may perform some or all of the steps in embodiments of this application. These steps or operations are merely examples. In embodiments of this application, other operations or variations of various operations may be further performed. In addition, the steps may be performed in a sequence different from a sequence presented in embodiments of this application, and not all operations in embodiments of this application need to be performed.

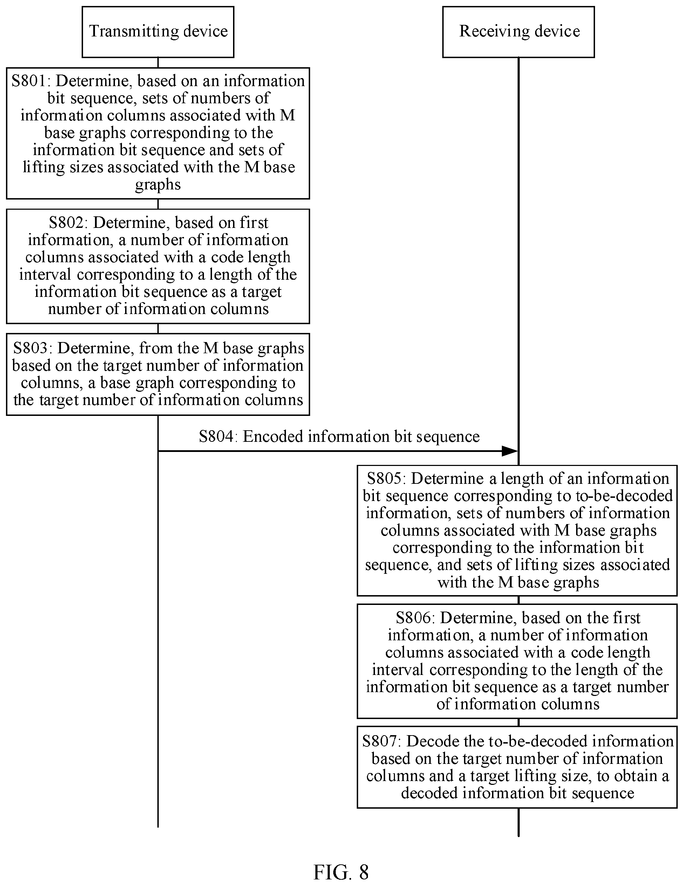

FIG. 8 is a diagram of interaction of a communication method according to this application. The communication method is described by using interaction between a transmitting device and a receiving device as an example. Unless otherwise specified, the "transmitting device" in this application may be the transmitting device, or may be a component (for example, a processor, a chip, or a chip system) in the transmitting device, or may be a logical module or software that can implement all or some functions of the transmitting device. Correspondingly, the "receiving device" in this application may be the receiving device, or may be a component (for example, a processor, a chip, or a chip system) in the receiving device, or may be a logical module or software that can implement all or some functions of the receiving device. For example, refer to FIG. 8. The communication method includes the following steps.

S801: The transmitting device determines, based on an information bit sequence, sets of numbers of information columns associated with M base graphs corresponding to the information bit sequence and sets of lifting sizes associated with the M base graphs.

M is a positive integer greater than or equal to 2.

The set of lifting sizes may include I lifting sizes, and 1≤i≤I. The set of numbers of information columns may include J numbers of information columns, and 1≤j≤J.

The I lifting sizes in the set of lifting sizes may be lifting sizes in a sum of the sets of lifting sizes associated with the M base graphs, or may be lifting sizes in an intersection set of the sets of lifting sizes associated with the M base graphs. Similarly, the J numbers of information columns in the set of numbers of information columns may be numbers of information columns in a sum of the sets of numbers of information columns associated with the M base graphs, or may be numbers of information columns in an intersection set of the sets of numbers of information columns associated with the M base graphs.

Optionally, the M base graphs may include one or more of the following base graphs: a base graph 1, a base graph 2, a base graph 3 (BG 3), or a nested base graph (the nested base graph may also be referred to as a single nested base graph, a single base graph, or a nested single base graph, and is uniformly referred to as a nested base graph in this application).

The nested base graph may include information columns of at least two base graphs.

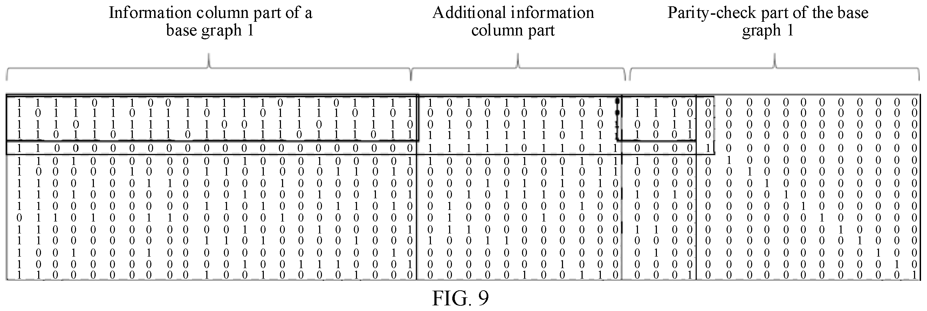

For example, as shown in FIG. 9, an additional information column part may be added to the nested base graph based on the base graph 1.

Connection relationships and shifting values of the nested base graph may be shown in Table 1. A row index of the nested base graph may be used to store a column of the nested base graph associated with a row, and shifting values corresponding to the row and the column. The nested base graph may be determined based on Table 1.

**Table 1 Shifting values of a nested base graph**

| Nested base graph | | Shifting value | | | | | | | |
|---|---|---|---|---|---|---|---|---|---|
| Row | Column | Shifting value index | | | | | | | |
| | | 0 | 1 | 2 | 3 | 4 | 5 | 6 | 7 |
| | 0 | 250 | 307 | 73 | 223 | 211 | 294 | 0 | 135 |
| | 1 | 69 | 19 | 15 | 16 | 198 | 118 | 0 | 227 |
| | 2 | 226 | 50 | 103 | 94 | 188 | 167 | 0 | 126 |
| | 3 | 159 | 369 | 49 | 91 | 186 | 330 | 0 | 134 |
| | 5 | 100 | 181 | 240 | 74 | 219 | 207 | 0 | 84 |
| | 6 | 10 | 216 | 39 | 10 | 4 | 165 | 0 | 83 |
| | 9 | 59 | 317 | 15 | 0 | 29 | 243 | 0 | 53 |
| 0 | 10 | 229 | 288 | 162 | 205 | 144 | 250 | 0 | 225 |
| | 11 | 110 | 109 | 215 | 216 | 116 | 1 | 0 | 205 |
| | 12 | 191 | 17 | 164 | 21 | 216 | 339 | 0 | 128 |
| | 13 | 9 | 357 | 133 | 215 | 115 | 201 | 0 | 75 |
| | 15 | 195 | 215 | 298 | 14 | 233 | 53 | 0 | 135 |
| | 16 | 23 | 106 | 110 | 70 | 144 | 347 | 0 | 217 |
| | 18 | 190 | 242 | 113 | 141 | 95 | 304 | 0 | 220 |
| | 19 | 35 | 180 | 16 | 198 | 216 | 167 | 0 | 90 |
| | 20 | 239 | 330 | 189 | 104 | 73 | 47 | 0 | 105 |
| | 21 | 31 | 346 | 32 | 81 | 261 | 188 | 0 | 137 |
| | 22 | 1 | 1 | 1 | 1 | 1 | 1 | 0 | 1 |
| | 23 | 0 | 0 | 0 | 0 | 0 | 0 | 0 | 0 |

In the foregoing table, the shifting values corresponding to row 0 and indexes {0, 1, 2, 3, 4, 5, 6, 7} of the shifting values are used for example. When the shifting value index is 0, a shifting value of row 0 and column 0 of the nested base graph is 250; or when the shifting value index is 5, a shifting value of row 0 and column 12 of the nested base graph is 339.

For determining of the base graph, optionally, some information columns may be extracted from a base graph with a larger number of information columns, to derive a base graph with a smaller number of information columns (for example, the base graph 2 may be derived from the base graph 1, and the base graph 3 may be derived from the base graph 2; or the base graph 2 may be derived from the base graph 1, and the base graph 3 may be derived from the base graph 1).

For example, the base graph 2 is derived from the base graph 1. All parity-check columns, all punctured columns, and a part of non-punctured columns in the base graph 1 (for example, for column groups of the base graph 1, one group includes three adjacent columns, and the part of the non-punctured columns may be a first column and a second column of all the column groups of the base graph 1) may be used as information columns of the base graph 2. The base graph 2 may be determined based on the information columns of the base graph 2, and all connection relationships and shifting values of the base graph 1.

For example, for the column groups of the base graph 1 (or the base graph 2), one group includes three adjacent columns. When the base graph 3 is derived from the base graph 1, the part of non-punctured columns may be the first column of all the column groups of the base graph 1; or when the base graph 3 is derived from the base graph 2, the part of non-punctured columns may be a first column of all the column groups of the base graph 2.

It may be understood that one or more of the following base graphs may be derived from the nested base graph: the base graph 1, the base graph 2, or the base graph 3.

Optionally, the transmitting device may determine, based on a length and/or a code rate of the information bit sequence, the M base graphs corresponding to the information bit sequence; or the transmitting device may determine, based on a communication scenario, the M base graphs corresponding to the communication scenario.

For example, it may be understood that the M base graphs may be all base graphs that support the communication scenario. For example, for an eMBB channel, the M base graphs may include the base graph 1 and the base graph 2; or for a communication scenario in which a throughput exceeds 200 Gbps or 100 Gbps in a 6G mobile communication system (or a communication scenario in which a code rate is higher than 22/24, an enhanced eMBB channel, or the like), the M base graphs may include another base graph than the base graph 1 and the base graph 2.

Optionally, sets of numbers of information columns associated with any two base graphs in the M base graphs may be the same or may be different (for example, some numbers of information columns in the sets of numbers of information columns associated with the any two base graphs are the same, or the sets of numbers of information columns associated with the any two base graphs are completely different). Similarly, sets of lifting sizes associated with any two base graphs in the M base graphs may be the same or may be different (for example, some lifting sizes in the sets of lifting sizes associated with the any two base graphs are the same, or the sets of lifting sizes associated with the any two base graphs are completely different).

For example, the M base graphs include the base graph 1 and the base graph 2. The sets of numbers of information columns are a set of numbers of information columns associated with the base graph 1 and a set of numbers of information columns associated with the base graph 2, and the sets of lifting sizes are a set of lifting sizes associated with the base graph 1 and a set of lifting sizes associated with the base graph 2.

For another example, when the communication scenario is a high throughput scenario, numbers of information columns associated with each of the M base graphs may be {22, 24, 30, 33}; or when the communication scenario is a URLLC scenario, the numbers of information columns associated with each of the M base graphs may be {8, 10, 14, 16}.

Optionally, the length of the information bit sequence may be the length of the information bit sequence including cyclic redundancy check (cyclic redundancy check, CRC), or may be the length of the information bit sequence. This is not limited.

S802: The transmitting device determines, based on first information, a number of information columns associated with a code length interval corresponding to a length of the information bit sequence as a target number of information columns.

The first information in S802 indicates a number of information columns associated with each of a plurality of code length intervals.

For example, the code length intervals are (*a*₁, *b*₁], (*a*₂, *b*₂], ··· , (*aₖ*, *bₖ*]. The first information may indicate that a number of information columns associated with (*a*₁, *b*₁] is *K*₁, a number of information columns associated with (*a*₂*, b*₂] is *K*₂, ···, and a number of information columns associated with (*aₖ, bₖ*] is *K*ₖ.

Optionally, an intersection set of any two of the code length intervals may be an empty set.

In addition, optionally, an example is used in which the first information indicates Q code length intervals and P numbers of information columns. When the Q code length intervals include a plurality of code length interval groups, the plurality of code length interval groups are associated with a same set of numbers of information columns, and the set of numbers of information columns associated with the plurality of code length interval groups includes a plurality of numbers of information columns among the P numbers of information columns.

Q and P are positive integers.

For example, the P numbers of information columns are *K*₁*, K*₂*,* ..., *K_{P}, K*₁ *< K*₂ *<* ··· *< K_{P},* and the Q code length intervals are (*a*₁*, b*₁]*,* (*a*₂*, b*₂]*, ...,* (*a_{Q}, b_{Q}*]*.* The numbers of information columns associated with the Q code length intervals may correspond to one or more numbers (for example, {*K*₁*, K*₂, *K*₃}) of information columns in the P numbers of information columns in a fixed order. In other words, the numbers of information columns corresponding to (*a*₁*, b*₁]*,* (*a*₂*, b*₂]*, ... ,* (*a_{Q}, b_{Q}*] are always cyclic according to *K*₁*, K*₂, *K*₃*.*

For example, for a 1^{st} code length interval group, a number of information columns associated with (*a*₁*, b*₁] may be *K*₁*,* a number of information columns associated with (*a*₂*, b*₂] may be *K*₂, and a number of information columns associated with (*a*₃*, b*₃] may be *K*₃*.* Similarly, for a 2^{nd} code length interval group, a number of information columns associated with (*a*₄, *b*₄] may be *K*₁*,* a number of information columns associated with (*a*₅*, b*₅] may be *K*₂, and a number of information columns associated with (*a*₆, *b*₆] may be *K*₃*.* The rest can be deduced by analogy, so that numbers of information columns associated with all the code length intervals can be determined.

It may be understood that, when mark numbers of code length intervals increase, for example, the code length intervals associated with the added mark numbers of the code length intervals are (*a*_{*Q+*1}*, b*_{*Q+*1}], (*a*_{*Q+*2}*, b*_{*Q+*2}]*,* and (*a*_{*Q+*3}*, b*_{*Q*+3}]*,* a number of information columns associated with (*a*_{*Q+*1}*, b*_{*Q+*1}] may be *K*₁*,* a number of information columns associated with (*a*_{*Q+*2}*, b*_{*Q+*2}] may be *K*₂, and a number of information columns associated with (*a*_{*Q+*3}, *b*_{*Q+*3}] may be *K*₃*.*

Based on this possible embodiment, a number of information columns associated with each code length interval in each code length interval group can be determined. When a mark number of a code length interval increases, a number of information columns associated with the code length interval can be directly determined based on the plurality of numbers of information columns among the P numbers of information columns, thereby improving working efficiency of the transmitting device, and providing a feasible solution for determining the number of information columns associated with the code length interval.

Optionally, the first information may indicate that a number of information columns associated with a first code length interval is a first number of information columns, and a number of information columns associated with a second code length interval is a second number of information columns.

Each length value within the first code length interval is less than or equal to a first threshold, and each length value within the second code length interval is greater than the first threshold.

For example, when the length of the information bit sequence is less than or equal to the first threshold, a number of information columns associated with the information bit sequence is the first number of information columns; or when the length of the information bit sequence is greater than the first threshold, the number of information columns associated with the information bit sequence is the second number of information columns.

Based on this possible embodiment, the code length intervals may be divided based on a relationship between each length value and the first threshold, to provide a feasible solution for dividing the code length intervals. In addition, the number of information columns corresponding to the information bit sequence can be determined by comparing the length of the information bit sequence with the first threshold, thereby improving working efficiency of determining, by the transmitting device, the number of information columns corresponding to the information bit sequence.

Optionally, the first information may indicate an endpoint of the code length interval, and the endpoint of the code length interval may be $\frac{{K}_{j} \times {Z}_{max}}{z}$ or $\frac{{K}_{j} \times {Z}_{max}}{z} + 1$, where *Kⱼ* is the number of information columns associated with the code length interval.

For example, when there are a first number *K*₁ of information columns and a second number *K*₂ of information columns, and *K*₁ is less than *K*₂, a first code length interval may be $\left(\frac{{K}_{1} \times {Z}_{max}}{z + 1}+1,\frac{{K}_{2} \times {Z}_{max}}{z + 1}\right]$, and a number of information columns associated with the first code length interval is *K*₂; and a second code length interval is $\left(\frac{{K}_{2} \times {Z}_{max}}{z + 1}+1,\frac{{K}_{1} \times {Z}_{max}}{z}\right]$, and a number of information columns associated with the second code length interval is *K*₁.
z is a positive integer, *Zₘₐₓ* is a first value, and the first value is a predefined maximum lifting size.

For example, the first value may be 384.

Optionally, the first value may be a maximum lifting size supported by a communication protocol (for example, the communication protocol may be a 5G communication protocol, a 6G communication protocol, or a next-generation communication protocol), the first value may be a maximum lifting size supported by the transmitting device, or the first value may be a maximum lifting size supported by the receiving device.

It should be noted that $\frac{{K}_{j} \times {Z}_{max}}{z}$ may be $\left⌊\frac{{K}_{j} \times {Z}_{max}}{z}\right⌋$, and correspondingly, $\frac{{K}_{1} \times {Z}_{max}}{z} + 1$ may be $\left⌊\frac{{K}_{j} \times {Z}_{max}}{z}\right⌋ + 1$.

Based on this possible embodiment, an endpoint of the code length interval can be determined based on the number of information columns, or the number of information columns associated with the code length interval can be determined based on the endpoint of the code length interval. In addition, as a value of z increases, endpoints of different code length intervals can be determined based on the number of information columns. In other words, the different code length intervals are associated with the same numbers of information columns. This provides a feasible solution for determining the endpoint of the code length interval and the number of information columns associated with the code length interval.

Optionally, the first information may indicate a number of information columns (for example, a third number of information columns) associated with a code length interval other than a specific code length interval (for example, the number of information columns associated with the first code length interval is the first number of information columns, and the number of information columns associated with the second code length interval is the second number of information columns).

For example, the number of information columns associated with the first code length interval is the first number of information columns, and the number of information columns associated with the second code length interval is the second number of information columns. A third code length interval is a code length interval other than the first code length interval and the second code length interval, and a number of information columns associated with the third code length interval may be the third number of information columns.

Optionally, the number of information columns associated with the code length interval may be determined based on the sets of numbers of information columns and/or the sets of lifting sizes.

Specifically, the number of information columns associated with the code length interval is determined based on a target lifting size.

The target lifting size is determined by comparing X first metrics.

An x^{th} first metric among the X first metrics is determined based on the first value and an i^{th} lifting size.

X is greater than or equal to 2, and x=1, 2, ..., X.

The i^{th} lifting size may be an i^{th} lifting size in a first set of lifting sizes, or may be an i^{th} lifting size in the sets of lifting sizes. This application provides two possible designs.

In a first possible design, the i^{th} lifting size may be the i^{th} lifting size in the first set of lifting sizes.

The first set of lifting sizes may be determined based on the sets of lifting sizes and the sets of numbers of information columns. To be specific, each lifting size in the first set of lifting sizes is a lifting size corresponding to each number of information columns in the sets of numbers of information columns.

In a possible embodiment, the i^{th} lifting size is a minimum lifting size that is in the sets of lifting sizes and that supports a j^{th} number of information columns in the sets of numbers of information columns in meeting a second condition.

The second condition is that a product of the j^{th} number of information columns and a lifting size in the sets of lifting sizes is greater than or equal to each length value in the code length interval.

For example, *Kⱼ* may be multiplied by all lifting sizes in the sets of lifting sizes, that is, *Kⱼ* × Z₁, *Kⱼ* × Z₂, ···, *Kⱼ* × Zᵢ, ···, and *Kⱼ* × Z*_{I}*. A lifting size (for example, Z*ᵢ*) that is greater than or equal to each length value in the code length interval and that is a minimum value is selected. Therefore, Zᵢ is a lifting size corresponding to *Kⱼ*. Similarly, a lifting size corresponding to each number of information columns can be obtained.

It may be understood that the determined lifting size is a lifting size in the first set of lifting sizes.

Further, the X first metrics may be determined based on the lifting size in the first set of lifting sizes, and the target lifting size (for example, Z*ᵢ*) may be determined from the first set of lifting sizes by comparing the X metrics, so that a number (for example, *Kⱼ*) of information columns corresponding to Z*ᵢ* may be determined as the number of information columns associated with the code length interval.

In a second possible design, the i^{th} lifting size may be the i^{th} lifting size in the sets of lifting sizes.

A number of information columns corresponding to the i^{th} lifting size may be a j^{th} number of information columns.

In a possible embodiment, the j^{th} number of information columns is a minimum number of information columns that is in the sets of numbers of information columns and that supports the i^{th} lifting size in meeting a third condition.

The third condition is that a product of the i^{th} lifting size and a number of information columns in the sets of numbers of information columns is greater than or equal to each length value in the code length interval.

For example, Zᵢ may be multiplied by all numbers of information columns in the sets of numbers of information columns, that is, *K*₁ × Zᵢ, *K*₂ × Zᵢ, ···, *Kⱼ* × Zᵢ, ···, and *K_{J}* × Zᵢ. A number (for example, *Kⱼ*) of information columns that is greater than or equal to each length value in the code length interval and that is a minimum value is selected. Therefore, *Kⱼ* is a number of information columns corresponding to Zᵢ . Similarly, a number of information columns corresponding to each lifting size can be obtained.

It may be understood that the X first metrics may be determined based on the lifting size in the sets of lifting sizes, and the target lifting size (for example, Z*ᵢ*) may be determined from the sets of lifting sizes by comparing the X first metrics. Further, a number of information columns corresponding to the target lifting size may be determined according to the foregoing method, and the number (for example, *Kⱼ*) of information columns corresponding to Z*ᵢ* may be determined as the number of information columns associated with the code length interval.

It may be understood that a code length interval and a number of information columns associated with each code length interval may be determined based on a number of information columns corresponding to each length value. To be specific, starting from a length value 1, each length value may be traversed to determine a target number of information columns corresponding to each length value. A code length interval may be determined based on equal values of the target number of information columns, and a number of information columns associated with the code length interval may be further determined.

Optionally, the x^{th} first metric is a difference between the first value and a first product; the x^{th} first metric is a first ratio; or the x^{th} first metric is a difference between 1 and the first ratio.

The first product is a product of the i^{th} lifting size and a second metric, and the first ratio is a ratio of the first product to the first value.

The second metric is determined based on the first value and the i^{th} lifting size.

For example, the second metric may be represented by the following formula: $\left⌊{Z}_{max}/{Z}_{i}\right⌋$.

*Zₘₐₓ* is the first value, and *Zᵢ* is the i^{th} lifting size.

It may be understood that the second metric may be understood as a number of blocks that can be decoded in parallel, and the transmitting device may determine the first metric based on the second metric, to ensure that hardware resources are wasted as little as possible, thereby improving hardware resource utilization, and in particular, improving decoding performance.

Optionally, when the second metric is greater than a second threshold, the second metric is the second threshold.

The second threshold may be determined based on an actual communication status, an actual communication scenario, and/or a hardware capability of a communication apparatus.

For example, the second threshold is 7. When the second metric corresponding to the i^{th} lifting size is greater than 7, the second metric is 7. When the second metric corresponding to the i^{th} lifting size is less than or equal to 7 (for example, the second metric is 5), the second metric is 5. Alternatively, for example, the second threshold is 5. When the second metric corresponding to the i^{th} lifting size is greater than 5, the second metric is 5. When the second metric corresponding to the i^{th} lifting size is less than or equal to 5 (for example, the second metric is 2), the second metric is 2.

It may be understood that, when the second metric is excessively large, complexity of designing a cyclic shift network increases. In this application, the second metric may be limited by using the second threshold, to ensure that the second metric is as small as possible, thereby reducing computational complexity during decoding.

Based on the foregoing descriptions of the second metric, in a possible embodiment, a value range of the second metric may be 2 to 7, or the second metric may be 2 or 7.

Based on the foregoing descriptions of the first metric and the second metric, this application provides several possible examples of a representation form of the first metric.

In a first example, when the x^{th} first metric is the difference between the first value and the first product, the x^{th} first metric may be represented by the following formula: *Zₘₐₓ* - *Zᵢ* × *δᵢ*

*δᵢ* is the second metric corresponding to the i^{th} lifting size.

In a second example, when the x^{th} first metric is the first ratio, the x^{th} first metric may be represented by the following formula: (*Zᵢ* × *δᵢ*)/*Zₘₐₓ*

In a third example, when the x^{th} first metric is the difference between 1 and the first ratio, the x^{th} first metric may be represented by the following formula: 1 - (*Zᵢ* × *δᵢ*)/*Zₘₐₓ*

It may be understood that the x^{th} first metric can be determined based on the foregoing three methods, to provide a plurality of feasible solutions for determining the x^{th} first metric.

Based on the foregoing descriptions of determining the number of information columns associated with the code length interval, different from determining, by the transmitting device, the number of information columns based on the length of the information bit sequence, and then determining the target lifting size based on the number of information columns, in this application, the target lifting size can be determined by comparing the X first metrics. In this way, more feasible solutions can be provided for determining the target lifting size. In addition, it can be ensured that hardware resources are wasted as little as possible during determining of the target lifting size, thereby improving hardware resource utilization, and in particular, improving decoding performance.

S803: The transmitting device determines, from the M base graphs based on the target number of information columns, a base graph corresponding to the target number of information columns, where the base graph is used to encode the information bit sequence to obtain an encoded bit sequence.

The transmitting device may determine, from the M base graphs based on the target number of information columns, the base graph associated with the target number of information columns, and then encode the information bit sequence based on the base graph.

It may be understood that one base graph may be determined based on the target number of information columns (that is, an intersection set of the sets of number of information columns associated with the M base graphs is empty), and the transmitting device may encode the information bit sequence based on the base graph. Alternatively, a plurality of base graphs may be determined based on the target number of information columns (that is, the sets of numbers of information columns associated with the M base graphs are not empty sets). Further, the transmitting device may determine one base graph from the plurality of base graphs based on first indication information or a code rate of the information bit sequence, and encode the information bit sequence based on the base graph.

The first indication information indicates a communication scenario.

Optionally, when the transmitting device determines one base graph based on the target number of information columns, the transmitting device may determine a target information column from the base graph based on the target number (for example, *Kⱼ*) of information columns, form a new base graph by using the target information column, connection relationships of matrix regions corresponding to all parity-check columns of the base graph, and shifting values of the base graph, and encode the information bit sequence based on the new base graph.

The target information column may be the first *Kⱼ* information columns of the base graph, the target information column may be any information column extracted from the base graph, or the target information column may be information columns with an interval of 1 (or 2 or 3) in the base graph (for example, if the target number of information columns is 4, the target information column may be a first information column, a third information column, a fifth information column, and a seventh information column of the base graph).

Regardless of how the target information column is selected, the target information column includes a punctured column.

It may be understood that, after the target information column is determined, an unused information column in the base graph may be directly deleted (for example, the unused information column may be set to 0), and the information bit sequence is encoded based on the base graph in which the unused information column is deleted. Alternatively, after the unused information column in the base graph is deleted, the target information column may be renumbered to generate a new base graph, and the information bit sequence is encoded based on the new base graph.

It may be understood that the transmitting device can determine target information from the base graph based on the target number of information columns, and then encode the information bit sequence based on the target information columns. Different target information columns can be determined for information bit sequences with different lengths, thereby improving decoding performance.

S804: The transmitting device sends the encoded information bit sequence to the receiving device, and correspondingly, the receiving device receives to-be-decoded information from the transmitting device.

The transmitting device may map the encoded information bit sequence to frequency domain or time domain, to form a signal, and send the signal to the receiving device. Correspondingly, the receiving device may obtain the to-be-decoded information in the signal based on the received signal.

S805: The receiving device determines a length of an information bit sequence corresponding to the to-be-decoded information, sets of numbers of information columns associated with M base graphs corresponding to the information bit sequence, and sets of lifting sizes associated with the M base graphs.

It may be understood that the sets of numbers of information columns associated with the M base graphs and the sets of lifting sizes associated with the M base graphs are consistent with the sets of numbers of information columns associated with the M base graphs and the sets of lifting sizes associated with the M base graphs in S801. Details are not described herein again.

The to-be-decoded information may carry indication information indicating the length of the information bit sequence, and the receiving device may determine, based on the indication information, the length of the information bit sequence corresponding to the to-be-decoded information. Alternatively, the transmitting device may send, to the receiving device, control information that carries the length of the information bit sequence, and the receiving device may determine, based on the control information, the length of the information bit sequence corresponding to the to-be-decoded information. This is not limited.

S806: The receiving device uses, based on the first information, a number of information columns associated with a code length interval corresponding to the length of the information bit sequence as a target number of information columns.

For determining, by the receiving device, the code length interval and the number of information columns associated with the code length interval, refer to S802 in which the transmitting device determines the code length interval and the number of information columns associated with the code length interval. Details are not described herein again.

S807: The receiving device decodes the to-be-decoded information based on the target number of information columns and a target lifting size, to obtain a decoded information bit sequence.

The target lifting size is determined based on the sets of lifting sizes.

For determining the target lifting size by the receiving device, refer to S802 in which the transmitting device determines the target lifting size. Details are not described herein again.

Based on the communication method in FIG. 8, the transmitting device may determine the code length interval corresponding to the length of the information bit sequence, to explicitly determine, based on the first information, the number of information columns associated with the code length interval as the target number of information columns, thereby reducing computational complexity, and improving working efficiency of the transmitting device. In addition, different from determining, by the transmitting device, one base graph based on the information bit sequence, in this application, the M base graphs can be determined based on the information bit sequence. The M base graphs correspond to different numbers of information columns. The base graphs corresponding to the different numbers of information columns can reduce an overlapping peak area of a waste of resources, to greatly reduce a proportion of idle hardware resources, and further improve hardware resource utilization during decoding of to-be-decoded information of different lengths. Moreover, the transmitting device determines, from the M base graphs based on the target number of information columns, the base graph used for encoding (for example, when the target number of information columns corresponds to at least two base graphs, the base graph used for encoding may be determined from the M base graphs based on an actual communication scenario), to further improve hardware resource utilization, and improve decoding performance.

Based on the foregoing descriptions of determining the target lifting size by comparing the X first metrics in S802, optionally, the transmitting device may determine the target lifting size based on a minimum value or a minimum value of the X first metrics, or the transmitting device may determine the target lifting size based on Y first metrics among the X first metrics.

A y^{th} first metric among the Y first metrics is less than or equal to a third threshold corresponding to the y^{th} first metric, or the y^{th} first metric among the Y first metrics is greater than or equal to the third threshold corresponding to the y^{th} first metric.

Y is greater than or equal to 1, and y=1, 2, ..., Y.

In a first possible implementation, the transmitting device may determine the target lifting size based on the minimum value or the maximum value of the X first metrics.

When the transmitting device determines the minimum value or the maximum value of the X first metrics, there may be one minimum value or maximum value (a number of information columns and a lifting size that correspond to the minimum value are directly used as the target number of information columns and the target lifting size), or there may be at least two minimum values or maximum values. This application provides several possible embodiments.

In a first possible embodiment, when there is a maximum value or a minimum value, an example is used in which the first metric satisfies the following formula: *Zₘₐₓ* - *Zᵢ* × *δᵢ* or 1 - (*Zᵢ* × *δᵢ*)/*Zₘₐₓ* . A first metric corresponding to each lifting size may be determined, a minimum value (for example, an x^{th} first metric is the minimum value) is determined from the determined first metrics, and a lifting size (namely, *Z*ⱼ) corresponding to the x^{th} first metric may be used as the target lifting size. Alternatively, an example is used in which the first metric satisfies the following formula: (*Zᵢ* × *δᵢ*)/*Zₘₐₓ.* A first metric corresponding to each lifting size may be determined, a maximum value (for example, an x^{th} first metric is the maximum value) is determined from the determined first metrics, and a lifting size (namely, *Z*ᵢ) corresponding to the x^{th} first metric may be used as the target lifting size.

In a second possible embodiment, when there are at least two minimum values or maximum values, a lifting size with a maximum value or a minimum value in at least two lifting sizes corresponding to the at least two minimum values or maximum values is determined as the target lifting size. Alternatively, the target lifting size is determined, based on first indication information, from at least two lifting sizes corresponding to the at least two minimum values or maximum values.

The first indication information indicates a communication scenario.

For example, lifting sizes corresponding to two minimum values are respectively *Zᵢ* and *Zⱼ*, and *Zᵢ*>*Zⱼ*. *Zᵢ* may be determined as the target lifting size, or *Zⱼ* may be determined as the target lifting size.

For another example, lifting sizes corresponding to two minimum values are respectively *Zᵢ* and *Zⱼ*, and *Zᵢ*>*Zⱼ*. In a high throughput scenario, *Zᵢ* may be determined as the target lifting size, to prevent an excessively high code rate in the high throughput scenario. Alternatively, in a URLLC scenario, *Zⱼ* may be determined as the target lifting size, to meet requirements for a low code rate and a low latency in the URLLC scenario.

Based on the foregoing second possible embodiment, when there are at least two minimum values or maximum values, the target lifting size can be determined according to the foregoing two methods, and the target lifting size can be determined based on different communication requirements, to provide a plurality of feasible solutions for determining the target lifting size. Further, the target lifting size determined based on the different communication requirements can improve hardware resource utilization, and in particular, can improve decoding performance.

In a second possible implementation, the transmitting device may determine the target lifting size based on the Y first metrics among the X first metrics.

When the transmitting device determines the Y first metrics, where Y may be 1 (a number of information columns and a lifting size that correspond to the first metric are directly used as the target number of information columns and the target lifting size), or may be greater than 1. This application provides several possible embodiments.

In a first possible embodiment, when Y is 1, an example is used in which the first metric satisfies the following formula: *Zₘₐₓ* - *Zᵢ* × *δᵢ* or *Zₘₐₓ* - *Zᵢ* × *δᵢ*. A first metric corresponding to each lifting size may be determined, a first metric (for example, an x^{th} first metric) that is less than or equal to the third threshold is determined from the determined first metrics, and a lifting size (namely, *Z*ᵢ ) corresponding to the x^{th} first metric may be used as the target lifting size. Alternatively, an example is used in which the first metric satisfies the following formula: (*Zᵢ* × *δᵢ*)/*Zₘₐₓ*. A first metric corresponding to each lifting size may be determined, a first metric (for example, an x^{th} first metric) that is greater than or equal to the third threshold is determined from the determined first metrics, and a lifting size (namely, *Z*ᵢ) corresponding to the x^{th} first metric may be used as the target lifting size.

In a second possible embodiment, when Y is greater than 1, a lifting size with a maximum value or a minimum value in Y lifting sizes corresponding to the Y first metrics is determined as the target lifting size; or the target lifting size is determined, based on the first indication information, from the Y lifting sizes corresponding to the Y first metrics.

For example, Y is equal to 2, lifting sizes corresponding to the two first metrics are respectively *Zᵢ* and *Zⱼ*, and *Zᵢ*>*Zⱼ*. *Zᵢ* may be determined as the target lifting size, or *Zⱼ* may be determined as the target lifting size.

For another example, Y is equal to 2, lifting sizes corresponding to the two first metrics are respectively *Zᵢ* and *Zⱼ*, and *Zᵢ*>*Zⱼ*. In a high throughput scenario, *Zᵢ* may be determined as the target lifting size, to prevent an excessively high code rate in the high throughput scenario. Alternatively, in a URLLC scenario, *Zⱼ* may be determined as the target lifting size, to meet requirements for a low code rate and a low latency in the URLLC scenario.

Based on the foregoing second possible embodiment, when Y is greater than 1, the target lifting size can be more flexibly determined based on different communication requirements, to provide a plurality of feasible solutions for determining the target lifting size. Further, the target lifting size determined based on the different communication requirements can improve hardware resource utilization, and in particular, can improve decoding performance.

Based on the foregoing two possible implementations, the target lifting size is determined based on the minimum value or the maximum value, to ensure that hardware resources are wasted as little as possible, thereby improving hardware resource utilization, and in particular, improving decoding performance. Alternatively, the target lifting size is determined based on the Y first metrics, to provide more feasible solutions for determining the target lifting size. The target lifting size can be determined based on an actual communication status, thereby improving flexibility of determining the target lifting size.

Optionally, each of the X first metrics may correspond to one third threshold, and a third threshold corresponding to the x^{th} first metric may be determined based on the lifting size corresponding to the x^{th} first metric.

For example, the third threshold corresponding to the x^{th} first metric may be any one of the following: 1/3*Zᵢ*, 1/5*Zᵢ*, 2/5*Zᵢ*, or 1/4*Zᵢ*.

*Zᵢ* is the lifting size corresponding to the x^{th} first metric.

For another example, the third threshold corresponding to the x^{th} first metric may be any one of the following: 1/3, 1/5, 2/5, or 1/4.

Based on the foregoing two examples, optional values of the third threshold corresponding to the first metric are provided, to provide more feasible solutions for determining the third threshold corresponding to the first metric. In addition, the third threshold corresponding to the first metric may be determined based on an actual communication status, thereby improving flexibility of determining the third threshold.

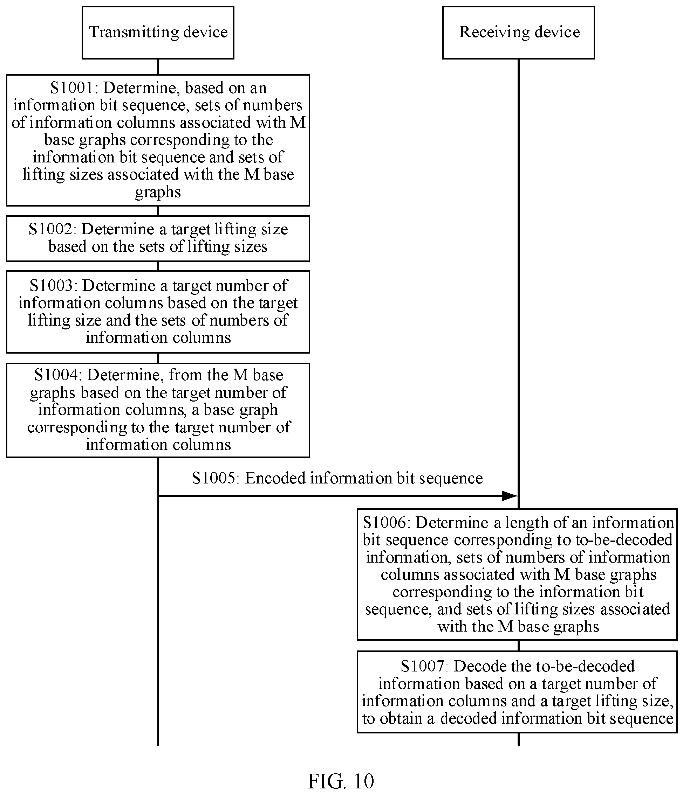

Optionally, this application further provides a communication method. Different from that in FIG. 8, the transmitting device determines the target number of information columns based on the number of information columns associated with the code length interval. As shown in FIG. 10, a transmitting device may determine a target number of information columns based on an information bit sequence. Specific steps may be as follows.

S1001: The transmitting device determines, based on an information bit sequence, sets of numbers of information columns associated with M base graphs corresponding to the information bit sequence and sets of lifting sizes associated with the M base graphs.

For S1001, refer to S801. Details are not described herein again.

S1002: The transmitting device determines a target lifting size based on the sets of lifting sizes.

It may be understood that the transmitting device may alternatively determine the target lifting size based on a first set of lifting sizes. The first set of lifting sizes may be determined based on the sets of lifting sizes and the sets of numbers of information columns.

The first set of lifting sizes is consistent with the first set of lifting sizes in S802. Details are not described herein again.

The target lifting size is determined by comparing X first metrics.

For determining, by the transmitting device, the target lifting size by comparing the X first metrics, refer to the determining, by the transmitting device, the target lifting size by comparing the X first metrics above. Details are not described herein again.

S1003: The transmitting device determines a target number of information columns based on the target lifting size and the sets of numbers of information columns.

An i^{th} lifting size corresponds to a j^{th} number of information columns in the sets of numbers of information columns.

In a first possible implementation, the i^{th} lifting size is a minimum lifting size that is in the sets of lifting sizes and that supports the j^{th} number of information columns in meeting a fourth condition.

The fourth condition is that a product of the j^{th} number of information columns and a lifting size in the sets of lifting sizes is greater than or equal to a length of the information bit sequence.

For determining the number of information columns corresponding to the i^{th} lifting size, refer to the determining the number of information columns corresponding to the i^{th} lifting size in S802. Details are not described herein again.

In a second possible implementation, the j^{th} number of information columns is a minimum number of information columns that is in the sets of numbers of information columns and that supports the i^{th} lifting size in meeting a fifth condition.

The fifth condition is that a product of the i^{th} lifting size and a number of information columns in the sets of numbers of information columns is greater than or equal to the length of the information bit sequence.

For determining the lifting size corresponding to the j^{th} number of information columns, refer to the determining the lifting size corresponding to the j^{th} number of information columns in S802. Details are not described herein again.

It may be understood that after determining the target lifting size (for example, the i^{th} lifting size), the transmitting device may determine, according to the foregoing method, the number of information columns (for example, the j^{th} number of information columns) corresponding to the target lifting size, and then may determine the j^{th} number of information columns as the target number of information columns.

S1004: The transmitting device determines, from the M base graphs based on the target number of information columns, a base graph corresponding to the target number of information columns.

The base graph is used to encode the information bit sequence to obtain an encoded bit sequence.

For S1004, refer to S803. Details are not described herein again.

S1005: The transmitting device sends the encoded information bit sequence to a receiving device, and correspondingly, the receiving device receives to-be-decoded information from the transmitting device.

For S1005, refer to S804. Details are not described herein again.

S1006: The receiving device determines a length of an information bit sequence corresponding to the to-be-decoded information, sets of numbers of information columns associated with M base graphs corresponding to the information bit sequence, and sets of lifting sizes associated with the M base graphs.

For S1006, refer to S805. Details are not described herein again.

S1007: The receiving device decodes the to-be-decoded information based on a target number of information columns and a target lifting size, to obtain a decoded information bit sequence.

Based on the communication method shown in FIG. 10, different from determining, by the transmitting device, one base graph based on the information bit sequence, in this application, the M base graphs can be determined based on the information bit sequence, to improve hardware resource utilization during decoding of to-be-decoded information of different lengths. Moreover, the transmitting device determines, from the M base graphs based on the target number of information columns, the base graph used for encoding, to further improve hardware resource utilization during decoding, and improve decoding performance.

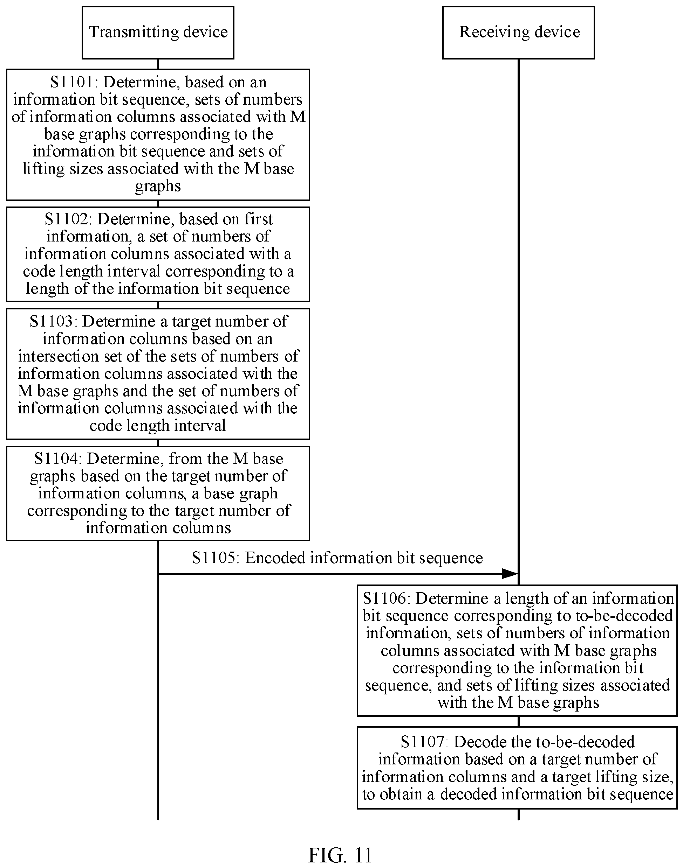

Optionally, this application further provides a communication method. Different from that in FIG. 8, the transmitting device determines, based on the first information, the number of information columns associated with the code length interval corresponding to the length of the information bit sequence as the target number of information columns, as shown in FIG. 11, a transmitting device may determine, based on first information, a set of numbers of information columns associated with a code length interval corresponding to a length of an information bit sequence, to further determine a target number of information columns. Specific steps may be as follows.

S1101: The transmitting device determines, based on the information bit sequence, sets of numbers of information columns associated with M base graphs corresponding to the information bit sequence and sets of lifting sizes associated with the M base graphs.

For S1101, refer to S801. Details are not described herein again.

S1102: The transmitting device determines, based on the first information, the set of numbers of information columns associated with the code length interval corresponding to the length of the information bit sequence.

The set of numbers of information columns associated with the code length interval is determined based on one or more first lifting sizes.

The one or more first lifting sizes are determined by comparing X first metrics.

The first metrics are consistent with the first metrics in S802. Details are not described herein again.

Optionally, the transmitting device may determine the one or more first lifting sizes based on a minimum value or a maximum value of the X first metrics; or the transmitting device may determine the one or more first lifting sizes based on Y first metrics among the X first metrics.

Further, the transmitting device may determine, based on a relationship between lifting sizes and numbers of information columns, a number of information columns corresponding to the one or more first lifting sizes as the set of numbers of information columns associated with the code length interval.

For the relationship between lifting sizes and numbers of information columns, refer to the foregoing descriptions in S802 in which the i^{th} lifting size corresponds to the j^{th} number of information columns in the sets of numbers of information columns. Details are not described herein again.

In a possible embodiment, for example, the transmitting device determines the one or more lifting sizes based on the minimum value of the X first metrics. When there is one minimum value, the transmitting device may determine a lifting size corresponding to the minimum value as the first lifting size; or when there are a plurality of minimum values, the transmitting device may determine lifting sizes corresponding to the plurality of minimum values as the plurality of first lifting sizes.

In another possible embodiment, for example, the transmitting device determines the one or more first lifting sizes based on the Y first metrics among the X first metrics. When Y is 1, the transmitting device may determine a lifting size corresponding to a first metric less than a third threshold as the first lifting size; or when Y is greater than 1, the transmitting device may determine lifting sizes corresponding to a plurality of first metrics less than the third threshold as the plurality of first lifting sizes.

S1103: The transmitting device determines the target number of information columns based on an intersection set of the sets of numbers of information columns associated with the M base graphs and the set of numbers of information columns associated with the code length interval.

In a possible implementation, when the intersection set includes one number of information columns, the number of information columns is used as the target number of information columns.

In another possible implementation, when the intersection set includes a plurality of numbers of information columns, the target number of information columns may be determined based on first indication information, or a maximum value/minimum value of the numbers of information columns in the intersection set may be determined as the target number of information columns, or a minimum number of information columns that is in the intersection set and that meets a third metric may be determined as the target number of information columns.

The first indication information indicates a communication scenario, the third metric is that a product of a number of information columns and a lifting size corresponding to the number of information columns is greater than or equal to the length of the information bit sequence, and the third metric may satisfy the following formula: *Kⱼ* × *Zᵢ* ≥ *K.*

K is the length of the information bit sequence.

For example, there are two numbers of information columns (*Kᵢ* and *Kⱼ,* where *Kᵢ*>*Kⱼ*)*.* In a high throughput scenario, *Kᵢ* may be determined as the target number of information columns, to prevent an excessively high code rate in the high throughput scenario. Alternatively, in a URLLC scenario, *Kⱼ* may be determined as the target number of information columns, to meet requirements for a low code rate and a low latency in the URLLC scenario.

In another example, there are two numbers of information columns ( *Kᵢ*and *Kⱼ,* where *Kᵢ*>*Kⱼ*), a lifting size corresponding to *Kᵢ* is *Zⱼ*, and a lifting size corresponding to *Kⱼ* is *Zᵢ*. It is determined whether values of *Kⱼ* × *Zᵢ* and *Kᵢ × Zⱼ* are greater than or equal to K. When the value of *Kⱼ* × *Zᵢ* is greater than or equal to K and the value of *Kᵢ* × *Zⱼ* is less than K, it may be determined that *Kⱼ* is the target number of information columns; when the value of *Kⱼ* × *Zᵢ* is less than K and the value of *Kᵢ* × *Zⱼ* is greater than or equal to K, it may be determined that *Kᵢ* is the target number of information columns; or when the value of *Kⱼ* × *Zᵢ* is greater than or equal to K and the value of *Kᵢ* × *Zⱼ* is greater than or equal to K, it may be determined that *Kᵢ* (or *Kⱼ*) is the target number of information columns.

S1104: The transmitting device determines, from the M base graphs based on the target number of information columns, a base graph corresponding to the target number of information columns.

The base graph is used to encode the information bit sequence to obtain an encoded bit sequence.

For S1104, refer to S803. Details are not described herein again.

S1105: The transmitting device sends the encoded information bit sequence to a receiving device, and correspondingly, the receiving device receives to-be-decoded information from the transmitting device.

For S1105, refer to S804. Details are not described herein again.

S1106: The receiving device determines a length of an information bit sequence corresponding to the to-be-decoded information, sets of numbers of information columns associated with M base graphs corresponding to the information bit sequence, and sets of lifting sizes associated with the M base graphs.

For S1106, refer to S805. Details are not described herein again.

S1107: The receiving device decodes the to-be-decoded information based on a target number of information columns and a target lifting size, to obtain a decoded information bit sequence.

Based on the communication method shown in FIG. 11, the transmitting device may determine the code length interval corresponding to the length of the information bit sequence, to explicitly determine, based on the first information, the set of numbers of information columns associated with the code length interval, and further determine the target number of information columns based on the intersection set of the set of numbers of information columns associated with the code length interval and the sets of numbers of information columns associated with the M base graphs, thereby reducing computational complexity, and improving working efficiency of the transmitting device. In addition, different from determining, by the transmitting device, one base graph based on the information bit sequence, in this application, the M base graphs can be determined based on the information bit sequence, to improve hardware resource utilization during decoding of to-be-decoded information of different lengths.

Based on the foregoing descriptions of the M base graphs and the sets of numbers of information columns associated with the M base graphs in FIG. 8 to FIG. 11, this application provides two possible implementations.

In one possible implementation, an intersection set of sets of numbers of information columns associated with any two of the M base graphs is an empty set. In other words, numbers of information columns in the sets of numbers of information columns associated with the any two of the M base graphs are different.

In a first possible embodiment, there is one number of information columns in a set of numbers of information columns associated with each base graph.

For example, a number of information columns associated with a base graph 1 may be 22, and a number of information columns associated with a base graph 2 may be 33. Alternatively, the number of information columns associated with the base graph 1 may be 22, and the number of information columns associated with the base graph 2 may be 44. Alternatively, the number of information columns associated with the base graph 1 may be 33, and the number of information columns associated with the base graph 2 may be 44.

Based on the foregoing embodiment, an existing coding scheme may be compatible. To be specific, when a number of information columns is 22, a base graph corresponding to the number of base graph columns may be directly used, thereby reducing design complexity of the base graph.

In a second possible embodiment, there are a plurality of numbers of information columns in a set of numbers of information columns associated with each base graph.

For example, a set of numbers of information columns associated with a base graph 1 may be {22, 23, 24}, and a set of numbers of information columns associated with a base graph 2 may be {33, 35, 36}.

Based on the foregoing embodiment, each base graph may support more numbers of information columns, and a corresponding number of information columns can be determined based on different lengths of information bit sequences.

Based on this possible implementation, the base graph can be directly determined based on the target number of information columns, to reduce computational complexity. In addition, a difference between the numbers of information columns associated with the base graphs is large, to reduce an overlapping peak area of a waste of hardware resources, and greatly reduce a proportion of idle hardware resources.

In another possible implementation, an intersection set of sets of numbers of information columns associated with at least two base graphs in the M base graphs is not an empty set. In other words, at least one number of information columns in the set of numbers of information columns may correspond to a plurality of base graphs.

In a possible embodiment, a set of numbers of information columns associated with a base graph 1 may be {22, 24, 26}, and a set of numbers of information columns associated with a base graph 2 may be {22, 23, 24, 25, 26}.

Based on this possible implementation, the base graph corresponding to the target number of information columns can be determined by using an additional criterion (for example, based on a code rate of the information bit sequence, or the first indication information). It can be ensured that the determined base graph (the determined base graph may be a base graph on which a shortening operation is performed) is as close as possible to a designed base graph (the designed base graph is a base graph on which no shortening operation is performed), thereby ensuring stable decoding performance.

Based on the communication methods shown in FIG. 8 to FIG. 11, this application further provides features of one or more base graphs in the M base graphs. Specific content is as follows.

Optionally, one or more base graphs in the M base graphs may have a column group feature. To be specific, for variable nodes of the base graph, one group may include k variable nodes (which may be adjacent variable nodes or may be non-adjacent variable nodes).

For example, a group of variable nodes may be represented as *C*₁, *C*₂, ... , *C_{T}*.

A column group structure of the base graph may be determined based on any row of the base graph and any group of variable nodes above.

Optionally, a column group structure of one or more base graphs in the M base graphs is column-regular. In other words, edges in a same group of each parity-check equation of the base graph are completely the same.

For example, for any row r of the base graph, |*N*(*r*) ∩ *Cₜ*| ∈ {0, *k*} may be satisfied.

*N*(*r*) is all columns of the base graph associated with the row r, *Cₜ* is a group of a t^{th} variable node, and k is a number of variable nodes in the group of variable nodes, and may also be referred to as a number of groups of the base graph (for example, k may be 2, 3, or 4).

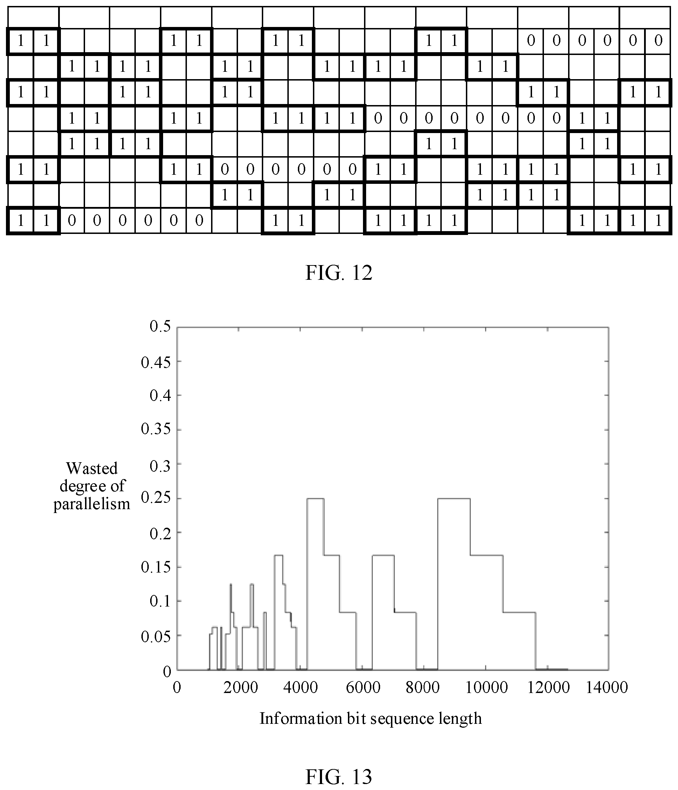

Based on the foregoing descriptions of the column group structure of the base graph, in a possible embodiment, the column group structure of the base graph may be shown in FIG. 12. There are two adjacent 1s in each part circled by a bold line. In this case, k may be 2.

It may be understood that a row weight of the base graph may be determined based on k, and the row weight may satisfy the following formula: k*t.$t = 1 , 2 , 3 , . . . , T .$

In a first possible implementation, a number of groups of one or more base graphs in the M base graphs is greater than or equal to a maximum value of a second metric.

The second metric is determined based on a first value and a c^{th} lifting size in a set of lifting sizes associated with the base graph.

The c^{th} lifting size is, in the set of lifting sizes associated with the base graph, a minimum lifting size that supports a d^{th} number of information columns in a set of numbers of information columns associated with the base graph in meeting a first condition.
c and d are positive integers.

The first condition is that a product of the d^{th} number of information columns and a lifting size in the set of lifting sizes associated with the base graph is greater than or equal to a fourth threshold.

The fourth threshold is determined based on the first value and a minimum number of information columns in the set of numbers of information columns associated with the base graph.

For example, the fourth threshold may be any one of the following: *K*₃ × *Zₘₐₓ*/2, *K*₃ × *Zₘₐₓ*/3, or *K*₃ × *Zₘₐₓ*/4.

*K*₃ is the minimum number of information columns, and *Zₘₐₓ* is the first value.

In a possible embodiment, for example, the set of numbers of information columns associated with the base graph is {*K*₁, *K*₂, *K*₃}*,* and the set of lifting sizes associated with the base graph is {*Z*₁, *Z*₂, *Z*₃}. For *K*₁, a minimum lifting size (for example, *Z*₁) whose product is greater than the fourth threshold may be determined from *K*₁ × *Z*₁, *K*₁ × *Z*₂, and *K*₁ × *Z*₃, to further determine a second metric (for example, ${δ}_{1} = \left⌊{Z}_{max}/{Z}_{1}\right⌋$) corresponding to *Z*₁. For *K*₂, a minimum lifting size (for example, *Z*₂) whose product is greater than the fourth threshold may be determined from *K*₂ × Z₁, *K*₂ × *Z*₂, and *K*₂ × *Z*₃, to further determine a second metric (for example, ${δ}_{2} = \left⌊{Z}_{max}/{Z}_{2}\right⌋$) corresponding to *Z*₂. For *K*₃, a minimum lifting size (for example, *Z*₃) whose product is greater than the fourth threshold may be determined from *K*₃ × *Z*₁, *K*₃ × *Z*₂, and *K*₃ × *Z*₃, to further determine a second metric (for example, ${δ}_{3} = \left⌊{Z}_{max}/{Z}_{3}\right⌋$) corresponding to *Z*₃. Further, a maximum value (for example, *δ*₃) of the foregoing three second metrics may be determined. In other words, the number of groups of the base graph may be greater than or equal to *δ*₃.

It may be understood that, the second metric may be limited according to the manner of limiting the second metric in S801 (that is, when the second metric is greater than the fourth threshold, the second metric is the fourth threshold). Details are not described herein again.

Based on this possible implementation, a feasible solution is provided for determining the number of groups of the base graph, to avoid as much as possible a case in which the number of groups of the base graph is large when the length of the information bit sequence is short, thereby reducing computational complexity of decoding, and improving flexibility of determining the number of groups of the base graph.

In a second possible implementation, when sets of numbers of information columns associated with N base graphs among the M base graphs include one number of information columns, a ratio of numbers of information columns associated with the N base graphs is equal to a ratio of numbers of groups associated with the N base graphs.

N is less than or equal to M.

In a possible embodiment, for example, the numbers of information columns associated with the N base graphs are *K*₁, *K*₂, ... , *Kₜ*, where *K*₁ ≤ *K*₂ ≤ ··· ≤ *Kₜ*; and numbers of groups of the base graphs associated with the N numbers of information columns are *k*₁, *k*₂, *... , kₜ.* In this case, *k*₁: *k*₂: ... : *kₜ* = *K*₁: *K*₂: ... : *Kₜ*.

For example, when *K*₁, *K*₂, and *K*₃ are respectively *K*₁, $\left⌊\frac{3}{2}{K}_{1}\right⌋$, and 2*K*₁, a number of groups of the base graph associated with *K*₁ may be 2, a number of groups of the base graph associated with $\left⌊\frac{3}{2}{K}_{1}\right⌋$ may be 3, and a number of groups of the base graph associated with 2*K*₁ may be 4.

Based on the communication methods shown in FIG. 8 to FIG. 11, this application further provides a feature of the set of numbers of information columns associated with the base graph. Specific content may be as follows.

Optionally, a maximum number of information columns in the set of numbers of information columns associated with the base graph is determined based on a first value and a second value; or the maximum number of information columns in the set of numbers of information columns associated with the base graph is determined based on a maximum value of a code rate supported by the base graph, a number of columns in a core parity-check region of the base graph, and a number of punctured columns of the base graph.

The second value is a maximum value of an information bit sequence length supported by the receiving device.

For example, when the maximum number of information columns in the set of numbers of information columns associated with the base graph is determined based on the first value and the second value, the maximum number of information columns may satisfy the following formula: ${K}_{max} \geq z \frac{{K}_{infor}}{{Z}_{max}}$.

*Kₘₐₓ* is the maximum number of information columns, *K_{infor}* is the second value, *Zₘₐₓ* is the first value, a value of z may be any one of the following: 1, 3/2, 4/3, 5/4, or 2, and z may be understood as a scaling coefficient.

For example, *Zₘₐₓ* is 384 and *K_{infor}* is 16896. When z is 1, *Kₘₐₓ* may be 44; or when z is 5/4, *Kₘₐₓ* may be 55.

For another example, when the maximum number of information columns in the set of numbers of information columns associated with the base graph is determined based on the maximum value of the code rate supported by the base graph, the number of columns in the core parity-check region of the base graph, and the number of punctured columns of the base graph, the maximum number of information columns may satisfy the following formula: ${K}_{max} \geq \frac{R \left(C-P\right)}{1 - R}$.

R is the maximum value of the code rate supported by the base graph, C is the number of columns in the core parity-check region of the base graph, and P is the number of punctured columns of the base graph.

Based on the foregoing descriptions of the maximum number of information columns, in a possible embodiment, the maximum number of information columns is any one of the following: 33, 44, or 55.

It may be understood that the maximum number of information columns in the set of numbers of information columns associated with the base graph can be explicitly determined based on the foregoing two examples.

Optionally, an interval between two adjacent numbers of information columns in the set of numbers of information columns associated with the base graph is determined based on the minimum number of information columns in the set of numbers of information columns associated with the base graph; the interval between two adjacent numbers of information columns in the set of numbers of information columns associated with the base graph is 1; or the interval between two adjacent numbers of information columns in the set of numbers of information columns associated with the base graph is 2.

The minimum number of information columns may be determined based on an actual communication status or an actual communication scenario.

For example, the minimum number of information columns may be 22.

When the minimum number of information columns is 22, the method in this application is applicable to an existing length of an information bit sequence, a code rate of an information bit sequence, and a communication scenario.

In a first example, when the interval between two adjacent numbers of information columns in the set of numbers of information columns associated with the base graph is determined based on the minimum number of information columns in the set of numbers of information columns associated with the base graph, the interval between two adjacent numbers of information columns may be any one of the following: $\left⌊\frac{{K}_{3}}{2}\right⌋ , \left⌈\frac{{K}_{3}}{2}\right⌉ , \left⌊\frac{{K}_{3}}{3}\right⌋ , \left⌈\frac{{K}_{3}}{2}\right⌉ , \left⌊\frac{{K}_{3}}{4}\right⌋$, or $\left⌈\frac{{K}_{3}}{4}\right⌉$.$\left⌊⋅\right⌋$ represents rounding down, $\left⌈⋅\right⌉$ represents rounding up, and *K*₃ is the minimum number of information columns.

For example, when the interval is $\left⌊\frac{{K}_{3}}{2}\right⌋$, the set of numbers of information columns associated with the base graph may be $\left\{{K}_{3}, \left⌊\frac{3}{2}{K}_{3}\right⌋, 2{K}_{3}\right\}$; or when the interval is $\left⌈\frac{{K}_{3}}{2}\right⌉$, the set of numbers of information columns associated with the base graph may be $\left\{{K}_{3},\left⌈\frac{3}{2}{K}_{3}\right⌉,2{K}_{3}\right\}$.

Based on this example, the interval between two adjacent numbers of information columns in the set of numbers of information columns associated with the base graph can be determined based on the minimum number of information columns in the set of numbers of information columns associated with the base graph, so that the interval between two adjacent numbers of information columns is large, thereby reducing design complexity of the base graph.

In a second example, when the interval between two adjacent numbers of information columns in the set of numbers of information columns associated with the base graph is 1, for example, the minimum number of information columns is *K*₃, the set of numbers of information columns associated with the base graph may be {*K*₃,*K*₃ + 1, ..., 2*K*₃ - 1}.

In a third example, when the interval between two adjacent numbers of information columns in the set of numbers of information columns associated with the base graph is 2, for example, the minimum number of information columns is *K*₃, the set of numbers of information columns associated with the base graph may be {*K*₃,*K*₃ + 2, ..., 2*K*₃ - 2}.

Based on the foregoing second and third possible examples, the interval between two adjacent numbers of information columns may be 1 or 2, so that optional values of the number of information columns can be increased, and corresponding numbers of information columns can be determined for information bit sequences with different lengths, thereby improving decoding performance.

Based on the foregoing descriptions of the feature of the set of numbers of information columns associated with the base graph, this application provides a possible embodiment. A value of a number of information columns in the sets of numbers of information columns associated with the M base graphs may be a product of a positive integer (for example, u) and a multiple (for example, v).
v is associated (for example, h=b-1) with an index of the base graph (that is, the index of the base graph may be h).

For example, u is 11. A number of information columns in a set of numbers of information columns associated with a 1^{st} base graph (that is, h is 1) may be 22 (that is, 11×2). A number of information columns in a set of numbers of information columns associated with a 2^{nd} base graph (that is, h is 2) may be 33 (that is, 11×3). A number of information columns in a set of numbers of information columns associated with a 3^{rd} base graph (that is, h is 3) may be 44 (that is, 11×4).

It may be understood that, different from that the set of numbers of information columns includes 22, in this application, 33 and 44 are further added, and corresponding numbers of information columns can be determined for information bit sequences with different lengths, thereby improving decoding performance.

Based on the communication methods shown in FIG. 8 to FIG. 12, several possible simulations are performed in this application.

In a first possible simulation, as shown in FIG. 13, a horizontal axis represents an information bit sequence length, and a vertical axis represents a wasted degree of parallelism. In the simulation, two base graphs corresponding to the information bit sequence are determined according to the method in this application, and numbers of information columns associated with the two base graphs are 22 and 33. While in FIG. 4, one base graph corresponding to the information bit sequence is determined according to a conventional technology, and the number of information columns associated with the base graph is 22. It can be learned from comparison between FIG. 13 and FIGs. 4a and 4b that, after the number 33 of information columns is increased, a peak area of a wasted degree of parallelism is low. Specifically, the wasted degree of parallelism may be reduced by half, thereby effectively improving hardware resource utilization during decoding of to-be-decoded information. In addition, a supported information bit sequence length increases from 9000 bits to about 14000 bits, to better adapt to large-capacity communication of a future mobile communication system.

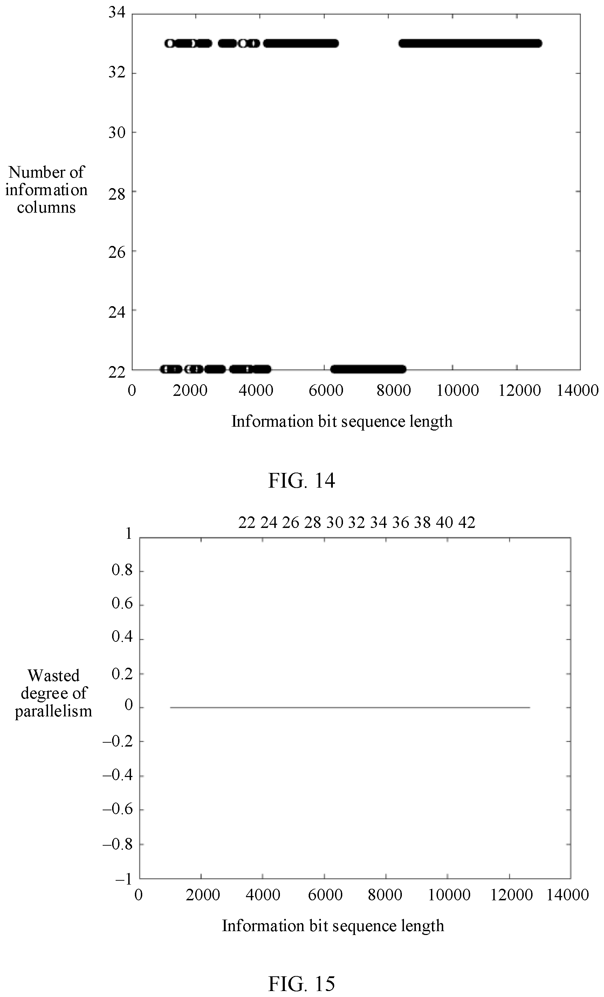

In a second possible simulation, as shown in FIG. 14, a horizontal axis represents an information bit sequence length, and a vertical axis represents a number of information columns. In the simulation, numbers of information columns corresponding to information bit sequences with different lengths are determined according to the method in this application. It can be learned that a number of information columns associated with the information bit sequence of a part of length is 22, and a number of information columns associated with the information bit sequence of another part of length is 33, so that information bit sequences with different lengths correspond to different numbers of information columns, thereby improving hardware resource utilization during decoding of to-be-decoded information.

In a third possible simulation, as shown in FIG. 15, a horizontal axis represents an information bit sequence length, and a vertical axis represents a wasted degree of parallelism. In the simulation, a nested base graph corresponding to the information bit sequence is determined according to the method in this application, and a set of numbers of information columns associated with the nested base graph is {22, 24, 26, 28, 30, 32, 34, 36, 38, 40, 42}. It can be learned that wasted degrees of parallelism corresponding to information bit sequences with different lengths are 0. In other words, after the number of information columns corresponding to the information bit sequence is determined by using the method in this application, hardware resource utilization during decoding of to-be-decoded information is 100%.

The set of numbers of information columns is {22, 24, 26, 28, 30, 32, 34, 36, 38, 40, 42}, so that a number of information columns in the set of numbers of information columns can be increased, to better adapt to information bit sequences with different lengths, and ensure that hardware resource utilization during decoding of to-be-decoded information is as high as possible.

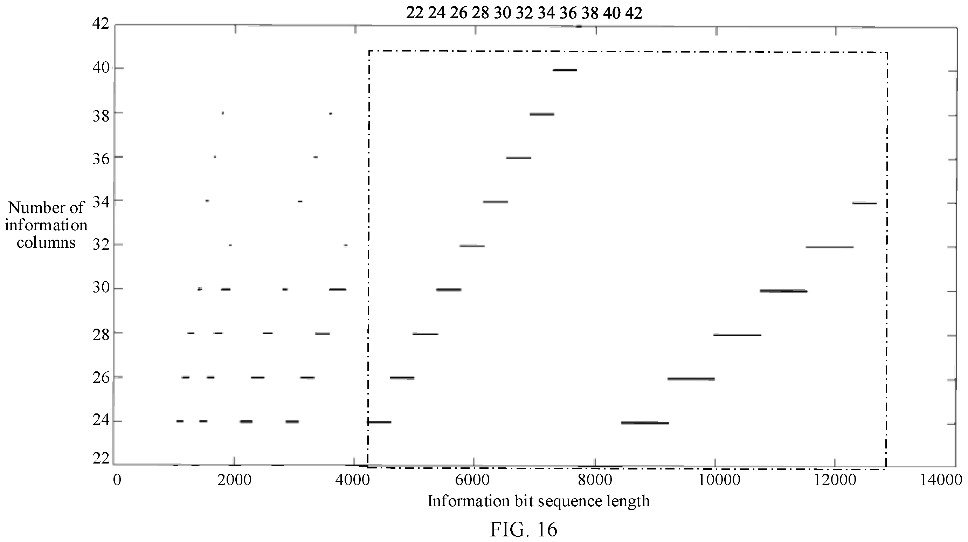

In a fourth possible simulation, as shown in FIG. 16, a horizontal axis represents an information bit sequence length, and a vertical axis represents a number of information columns. In the simulation, a nested base graph corresponding to the information bit sequence is determined according to the method in this application, and a set of numbers of information columns associated with the nested base graph is {22, 24, 26, 28, 30, 32, 34, 36, 38, 40, 42}. It can be learned that information bit sequences with different lengths correspond to different numbers of information columns. Compared with FIG. 14, there is a larger number of information columns in FIG. 16, and numbers of information columns corresponding to information bit sequences with different lengths can be more finely divided.

As shown in content in a dashed box in FIG. 16, a number of information columns corresponding to the information bit sequence when the information bit sequence length is greater than 4000 bits may be determined according to the method in this application. It can be learned that when the information bit sequence length is greater than 4000 bits, the number of information columns corresponding to the information bit sequence corresponds in a fixed order. To be specific, when the information bit sequence length is less than 4000 bits, numbers of information columns associated with code length subintervals in a code length interval may be 22, 24, 26, 28, 30, 32, 34, 36, and 38 sequentially; when the information bit sequence length is greater than 4000, and the code length interval is [4000, 8000], the numbers of information columns associated with the code length subintervals in the code length interval are 22, 24, 26, 28, 30, 32, 34, 36, 38, 40, and 42 sequentially; and when the code length interval is [8000, 12000], the numbers of information columns associated with the code length subintervals in the code length interval are 22, 24, 26, 28, 30, 32, and 34 sequentially, to better adapt to future large-capacity mobile communication.

It should be noted that improving the hardware resource utilization during decoding can bring a decoding performance gain, and the gain may be 0.5 dB.

It may be understood that, when information bit sequences of a same length are decoded based on different numbers of information columns, bit error rates may be different. Details are shown in the following simulations.

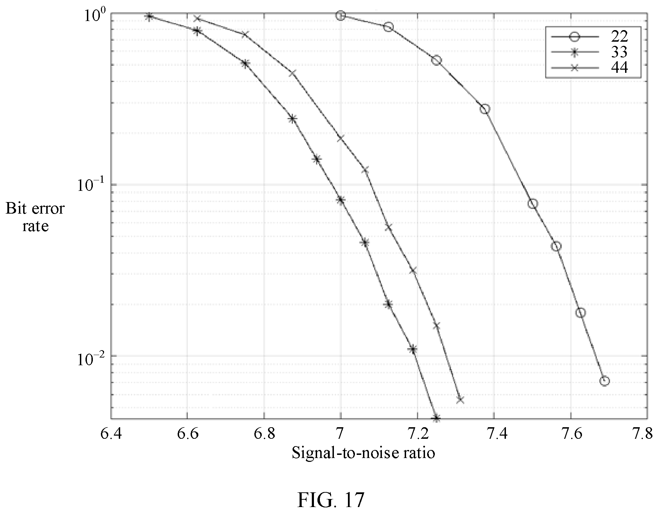

In a fifth possible simulation, as shown in FIG. 17, a horizontal axis represents a signal-to-noise ratio, a vertical axis represents a bit error rate, a length of an information bit sequence is 4225 bits, and a code rate of the information bit sequence is 0.917. In the simulation, when a number of information columns is 22, a number of parallel blocks is 1; when the number of information columns is 33, the number of parallel blocks is 1; or when the number of information columns is 44, the number of parallel blocks is 2. It can be learned that, when signal-to-noise ratios are the same, a bit error rate corresponding to the number 22 of information columns is the largest, and a bit error rate corresponding to the number 33 of information columns is the smallest. In other words, when the number of information columns is 33, hardware resource utilization is the highest and decoding performance is the best during decoding of to-be-decoded information.

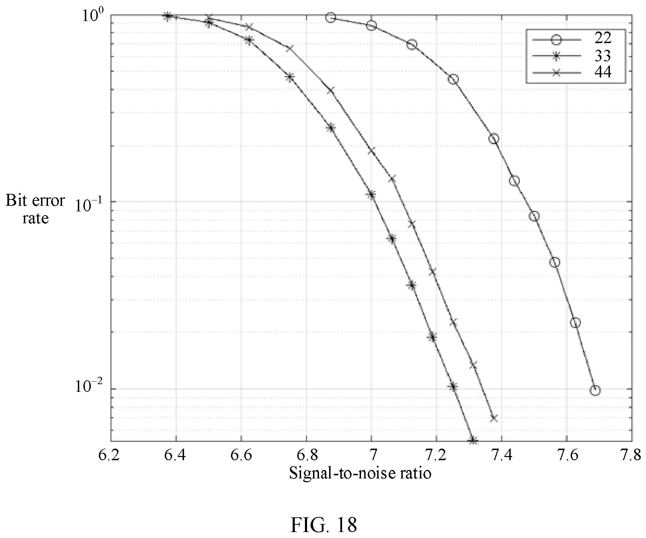

In a sixth possible simulation, as shown in FIG. 18, a horizontal axis represents a signal-to-noise ratio, a vertical axis represents a bit error rate, a length of an information bit sequence is 6336 bits, and a code rate of the information bit sequence is 0.917. In the simulation, when a number of information columns is 22, a number of parallel blocks is 1; when the number of information columns is 33, the number of parallel blocks is 2; or when the number of information columns is 44, the number of parallel blocks is 2. It can be learned that, when signal-to-noise ratios are the same, a bit error rate corresponding to the number 22 of information columns is the largest, and a bit error rate corresponding to the number 33 of information columns is the smallest. In other words, when the number of information columns is 33, hardware resource utilization is the highest and decoding performance is the best during decoding of to-be-decoded information.

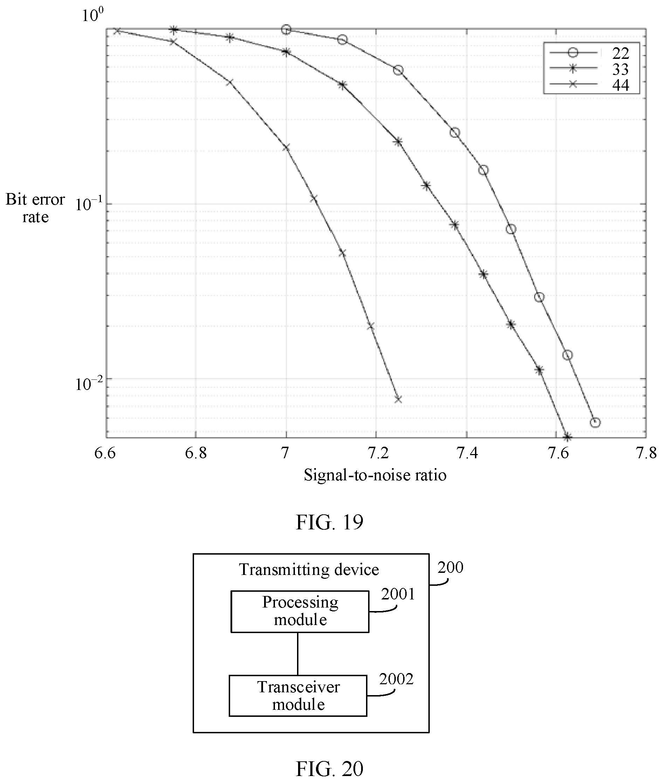

In a seventh possible simulation, as shown in FIG. 19, a horizontal axis represents a signal-to-noise ratio, a vertical axis represents a bit error rate, a length of an information bit sequence is 8448 bits, and a code rate of the information bit sequence is 0.917. In the simulation, when a number of information columns is 22, a number of parallel blocks is 1; when the number of information columns is 33, the number of parallel blocks is 2; or when the number of information columns is 44, the number of parallel blocks is 2. It can be learned that, when signal-to-noise ratios are the same, a bit error rate corresponding to the number 22 of information columns is the largest, and a bit error rate corresponding to the number 33 of information columns is the smallest. In other words, when the number of information columns is 33, hardware resource utilization is the highest and decoding performance is the best during decoding of to-be-decoded information.

Based on the fifth, sixth, and seventh possible simulations, it can be learned that an optimal number of information columns presents segmentation characteristics as the length of the information bit sequence increases. In addition, because the numbers of information columns may alternatively be 33 and 44, a better number of information columns can be determined for information bit sequences with different lengths, thereby improving hardware resource utilization during decoding of to-be-decoded information of different lengths, and improving decoding performance.

It should be noted that various embodiments of this application may be implemented separately, or may be implemented in combination. This is not limited. Unless otherwise stated or there is a logic conflict, terms and/or descriptions in different embodiments provided by this application are consistent and may be mutually referenced, and technical features in different embodiments may be combined based on an internal logical relationship thereof, to form a new embodiment.

It may be understood that, in embodiments of this application, an execution body may perform some or all of the steps in embodiments of this application. These steps or operations are merely examples. In embodiments of this application, other operations or variations of various operations may be further performed. In addition, the steps may be performed in a sequence different from a sequence presented in embodiments of this application, and not all operations in embodiments of this application need to be performed.

The foregoing mainly describes the solutions provided in this application from the perspective of interaction between devices. Correspondingly, this application further provides a communication apparatus, and the communication apparatus is configured to implement the foregoing methods. The communication apparatus may be the transmitting device in the foregoing method embodiments, or an apparatus including the transmitting device, or a component that can be used in the transmitting device. Alternatively, the communication apparatus may be the transmitting device in the foregoing method embodiments, or an apparatus including the transmitting device, or a component that can be used in the transmitting device.

It may be understood that, to implement the foregoing functions, the communication apparatus includes corresponding hardware structures and/or software modules for performing the functions. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraint conditions of the technical solutions. A person skilled in the art may use different methods to implement the described functions for each particular application, but it should not be considered that the implementation goes beyond the scope of this application.

In embodiments of this application, the communication apparatus may be divided into functional modules based on the foregoing method embodiments. For example, each functional module may be obtained through division based on each corresponding function, or two or more functions may be integrated into one processing module. The integrated module may be implemented in a form of hardware, or may be implemented in a form of a software functional module. It should be noted that, in embodiments of this application, module division is an example, and is merely a logical function division. In actual implementation, another division manner may be used.

In an implementation scenario, an example in which the communication apparatus is the transmitting device in the foregoing method embodiments is used. FIG. 20 is a diagram of a structure of a transmitting device 200. The transmitting device 200 includes a processing module 2001 and a transceiver module 2002.

In some embodiments, the transmitting device 200 may further include a storage module (not shown in FIG. 20), configured to store program instructions and data.

In some embodiments, the transceiver module 2002 may also be referred to as a transceiver unit, configured to implement a sending function and/or a receiving function. The transceiver module 2002 may include a transceiver circuit, a transceiver machine, a transceiver, or a communication interface.

In some embodiments, the transceiver module 2002 may include a receiving module and a sending module, respectively configured to perform receiving and sending steps performed by the transmitting device in the method embodiments, and/or configured to support another process of the technologies described in this specification. The processing module 2001 may be configured to perform processing (for example, determining and generation) steps performed by the transmitting device in the method embodiments, and/or configured to support another process of the technologies described in this specification.

For example, the processing module 2001 is configured to determine, based on an information bit sequence, sets of numbers of information columns associated with M base graphs corresponding to the information bit sequence and sets of lifting sizes associated with the M base graphs, where M is a positive integer greater than or equal to 2. The processing module 2001 is further configured to determine, based on first information, a number of information columns associated with a code length interval corresponding to a length of the information bit sequence as a target number of information columns, where the first information indicates a number of information columns associated with each of a plurality of code length intervals, and the number of information columns associated with the code length interval is determined based on the sets of numbers of information columns and/or the sets of lifting sizes. The processing module 2001 is further configured to determine, from the M base graphs based on the target number of information columns, a base graph corresponding to the target number of information columns, where the base graph is used to encode the information bit sequence to obtain an encoded bit sequence.

For another example, the processing module 2001 is configured to determine, based on an information bit sequence, sets of numbers of information columns associated with M base graphs corresponding to the information bit sequence and sets of lifting sizes associated with the M base graphs, where M is a positive integer greater than or equal to 2. The processing module 2001 is further configured to determine a target lifting size based on the sets of lifting sizes. The processing module 2001 is further configured to determine a target number of information columns based on the target lifting size and the sets of numbers of information columns. The processing module 2001 is further configured to determine, from the M base graphs based on the target number of information columns, a base graph corresponding to the target number of information columns, where the base graph is used to encode the information bit sequence to obtain an encoded bit sequence.

In this application, the transmitting device 200 is presented in a form of obtaining each functional module through division in an integrated manner. The "module" herein may be an application-specific integrated circuit (application-specific integrated circuit, ASIC), a circuit, a processor that executes one or more software or firmware programs, a memory, an integrated logic circuit, and/or another component that can provide the foregoing functions.

In some embodiments, in hardware implementation, a person skilled in the art may figure out that the transmitting device 200 may be in a form of the communication apparatus 70 shown in FIG. 7.

For example, functions/implementation processes of the processing module 2001 in FIG. 20 may be implemented by the processor 701 in the communication apparatus 70 shown in FIG. 7 by invoking computer-executable instructions stored in the memory 703. Functions/implementation processes of the transceiver module 2002 shown in FIG. 20 may be implemented through the communication interface 704 in the communication apparatus 70 shown in FIG. 7.

In some embodiments, when the transmitting device 200 in FIG. 20 is a chip or a chip system, the functions/implementation processes of the transceiver module 2002 may be implemented through an input/output interface (or a communication interface) of the chip or the chip system, and the functions/implementation processes of the processing module 2001 may be implemented through a processor (or a processing circuit) of the chip or the chip system.

The transmitting device 200 provided in this embodiment may perform the foregoing method. Therefore, for technical effects that can be obtained by the terminal device, refer to the foregoing method embodiments. Details are not described herein again.

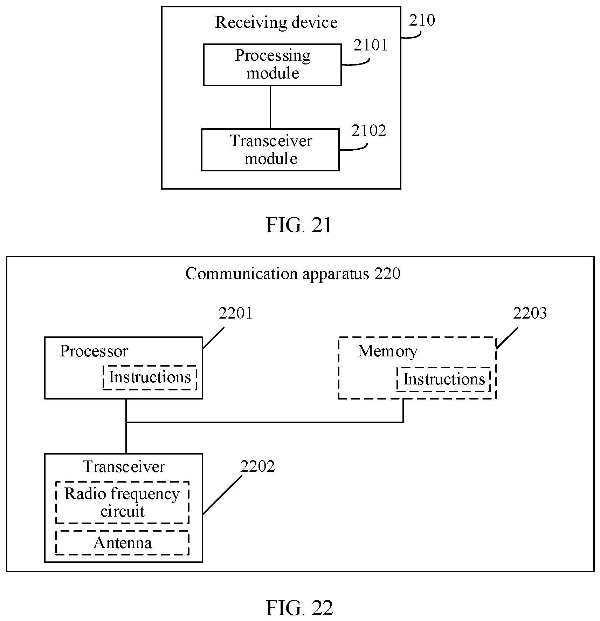

In another implementation scenario, an example in which the communication apparatus is the receiving device in the foregoing method embodiments is used. FIG. 21 is a diagram of a structure of a receiving device 210. The receiving device 210 includes a processing module 2101 and a transceiver module 2102.

In some embodiments, the receiving device 210 may further include a storage module (not shown in FIG. 21), configured to store program instructions and data.

In some embodiments, the transceiver module 2102 may also be referred to as a transceiver unit, configured to implement a sending function and/or a receiving function. The transceiver module 2102 may include a transceiver circuit, a transceiver machine, a transceiver, or a communication interface.

In some embodiments, the transceiver module 2102 may include a receiving module and a sending module, respectively configured to perform receiving and sending steps performed by the receiving device in the method embodiments, and/or configured to support another process of the technologies described in this specification. The processing module 2101 may be configured to perform processing (for example, determining and generation) steps performed by the receiving device in the method embodiments, and/or configured to support another process of the technologies described in this specification.

For example, the transceiver module 2102 is configured to obtain to-be-decoded information from a transmitting device. The processing module 2101 is configured to determine a length of an information bit sequence corresponding to the to-be-decoded information, sets of numbers of information columns associated with M base graphs corresponding to the information bit sequence, and sets of lifting sizes associated with the M base graphs, where M is greater than or equal to 2. The processing module 2101 is further configured to determine, based on first information and the length of the information bit sequence, a number of information columns associated with a code length interval corresponding to the length of the information bit sequence as a target number of information columns, where the first information indicates a number of information columns associated with each of a plurality of code length intervals, and the number of information columns associated with the code length interval is determined based on the sets of numbers of information columns and/or the sets of lifting sizes. The processing module 2101 is further configured to decode the to-be-decoded information based on the target number of information columns and a lifting size, to obtain a decoded information bit sequence, where a target lifting size is determined based on the sets of lifting sizes.

For another example, the transceiver module 2102 is configured to obtain to-be-decoded information from a transmitting device. The processing module 2101 is configured to determine sets of numbers of information columns associated with M base graphs corresponding to the information bit sequence, and sets of lifting sizes associated with the M base graphs, where M is a positive integer greater than or equal to 2. The processing module 2101 is further configured to decode the to-be-decoded information based on a target number of information columns and a target lifting size, to obtain a decoded information bit sequence, where the target number of information columns and the target lifting size are determined based on the sets of numbers of information columns and the sets of lifting sizes.

In this application, the receiving device 210 is presented in a form of obtaining each functional module through division in an integrated manner. The "module" herein may be an application-specific integrated circuit (application-specific integrated circuit, ASIC), a circuit, a processor that executes one or more software or firmware programs, a memory, an integrated logic circuit, and/or another component that can provide the foregoing functions.

In some embodiments, in hardware implementation, a person skilled in the art may figure out that the receiving device 210 may be in a form of the communication apparatus 70 shown in FIG. 7.

For example, functions/implementation processes of the processing module 2101 in FIG. 21 may be implemented by the processor 701 in the communication apparatus 70 shown in FIG. 7 by invoking computer-executable instructions stored in the memory 703. Functions/implementation processes of the transceiver module 2102 shown in FIG. 21 may be implemented through the communication interface 704 in the communication apparatus 70 shown in FIG. 7.

In some embodiments, when the receiving device 210 in FIG. 21 is a chip or a chip system, the functions/implementation processes of the transceiver module 2102 may be implemented through an input/output interface (or a communication interface) of the chip or the chip system, and the functions/implementation processes of the processing module 2101 may be implemented through a processor (or a processing circuit) of the chip or the chip system.

The receiving device 210 provided in this embodiment may perform the foregoing method. Therefore, for technical effects that can be obtained by the terminal device, refer to the foregoing method embodiments. Details are not described herein again.

In a possible product form, the transmitting device or the receiving device described in embodiments of this application may alternatively be implemented by using one or more field programmable gate arrays (field programmable gate arrays, FPGAs), a programmable logic device (programmable logic device, PLD), a controller, a state machine, gate logic, a discrete hardware component, any other proper circuit, or any combination of circuits that can perform various functions described in this application.

In another possible product form, the transmitting device or the receiving device in embodiments of this application may be implemented by using a general bus architecture. For ease of description, FIG. 22 is a diagram of a structure of a communication apparatus 220 according to an embodiment of this application. The communication apparatus 220 includes a processor 2201 and a transceiver 2202. The communication apparatus 220 may be a transmitting device, or a chip or a module in the transmitting device; or the communication apparatus 220 may be a receiving device, or a chip or a module in the receiving device. FIG. 22 shows only main components of the communication apparatus 220. In addition to the processor 2201 and the transceiver 2202, the communication apparatus may further include a memory 2203.

Optionally, the processor 2201 is mainly configured to: process a communication protocol and communication data, control the entire communication apparatus, execute a software program, and process data of the software program. The memory 2203 is mainly configured to store the software program and the data. The transceiver 2202 may include a radio frequency circuit and an antenna. The radio frequency circuit is mainly configured to: perform conversion between a baseband signal and a radio frequency signal, and process the radio frequency signal. The antenna is mainly configured to receive/send a radio frequency signal in a form of an electromagnetic wave.

Optionally, the processor 2201, the transceiver 2202, and the memory 2203 may be connected through a communication bus.

After the communication apparatus is powered on, the processor 2201 may read the software program in the memory 2203, interpret and execute instructions of the software program, and process the data of the software program. When data needs to be sent wirelessly, the processor 2201 performs baseband processing on the to-be-sent data, and then outputs a baseband signal to the radio frequency circuit. The radio frequency circuit performs radio frequency processing on the baseband signal, and then sends, through the antenna, a radio frequency signal in a form of an electromagnetic wave. When data is sent to the communication apparatus, the radio frequency circuit receives a radio frequency signal through the antenna, converts the radio frequency signal into a baseband signal, and outputs the baseband signal to the processor 2201; and the processor 2201 converts the baseband signal into data, and processes the data.

In another implementation, the radio frequency circuit and the antenna may be disposed independent of the processor that performs the baseband processing. For example, in a distributed scenario, the radio frequency circuit and the antenna may be disposed remotely and independent of the communication apparatus.

In some embodiments, an embodiment of this application further provides a communication apparatus. The communication apparatus includes a processor, configured to implement the method in any one of the foregoing method embodiments. The communication apparatus may be the transmitting device or the receiving device in the foregoing method embodiments.

In a possible implementation, the communication apparatus further includes a memory. The memory is configured to store a necessary computer program and data. The computer program may include instructions. The processor may invoke the instructions in the computer program stored in the memory, to instruct the communication apparatus to perform the method in any one of the foregoing method embodiments. Certainly, the memory may alternatively not be in the communication apparatus.

In another possible implementation, the communication apparatus further includes an interface circuit. The interface circuit is a code/data read/write interface circuit, and the interface circuit is configured to receive computer-executable instructions (the computer-executable instructions are stored in the memory, and may be directly read from the memory, or may be read via another component) and send the computer-executable instructions to the processor.

In still another possible implementation, the communication apparatus further includes a communication interface, and the communication interface is configured to communicate with a module other than the communication apparatus.

It may be understood that the communication apparatus may be a chip or a chip system. When the communication apparatus is the chip system, the communication apparatus may include a chip, or may include a chip and another discrete component. This is not specifically limited in embodiments of this application.

This application further provides a computer-readable storage medium. The computer-readable storage medium stores a computer program or instructions. When the computer program or the instructions are executed by a computer, functions in any one of the foregoing method embodiments are implemented.

This application further provides a computer program product. When the computer program product is executed by a computer, functions in any one of the foregoing method embodiments are implemented.

A person of ordinary skill in the art may understand that, for the purpose of convenient and brief description, for a detailed working process of the foregoing systems, apparatuses, and units, refer to a corresponding process in the foregoing method embodiment. Details are not described herein again.

It may be understood that the systems, apparatuses, and methods described in this application may alternatively be implemented in another manner. For example, the described apparatus embodiments are merely examples. For example, division into the units is merely logical function division, and may be other division in an actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may be physically separated or not, this is, may be located together in the same place or distributed on a plurality of network units. Parts displayed as units may be or may be not physical units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

All or some of the foregoing embodiments may be implemented by using software, hardware, firmware, or any combination thereof. When a software program is used to implement the embodiments, all or some of the embodiments may be implemented in a form of a computer program product. The computer program product includes one or more computer instructions. When the computer program instructions are loaded and executed on a computer, all or some of procedures (or functions) described in embodiments of this application are implemented. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid-state drive, SSD)), or the like. In embodiments of this application, the computer may include the foregoing apparatuses.

Although this application is described with reference to embodiments, in a process of implementing this application that claims protection, a person skilled in the art may understand and implement another variation of the disclosed embodiments by viewing the accompanying drawings, disclosed content, and appended claims. In the claims, "comprising" (comprising) does not exclude another component or another step, and "a" or "one" does not exclude a case of multiple. A single processor or another unit may implement several functions enumerated in the claims.

## Claims

1. A communication method, comprising:
determining, based on an information bit sequence, sets of numbers of information columns associated with M base graphs corresponding to the information bit sequence and sets of lifting sizes associated with the M base graphs, wherein M is a positive integer greater than or equal to 2;
determining, based on first information, a number of information columns associated with a code length interval corresponding to a length of the information bit sequence as a target number of information columns, wherein the first information indicates a number of information columns associated with each of a plurality of code length intervals, and the number of information columns associated with the code length interval is determined based on the sets of numbers of information columns and/or the sets of lifting sizes; and
determining, from the M base graphs based on the target number of information columns, a base graph corresponding to the target number of information columns, wherein the base graph is used to encode the information bit sequence to obtain an encoded bit sequence.

2. A communication method, comprising:
obtaining to-be-decoded information from a transmitting device, and determining a length of an information bit sequence corresponding to the to-be-decoded information, sets of numbers of information columns associated with M base graphs corresponding to the information bit sequence, and sets of lifting sizes associated with the M base graphs, wherein M is greater than or equal to 2;
determining, based on first information, a number of information columns associated with a code length interval corresponding to the length of the information bit sequence as a target number of information columns, wherein the first information indicates a number of information columns associated with each of a plurality of code length intervals, and the number of information columns associated with the code length interval is determined based on the sets of numbers of information columns and/or the sets of lifting sizes; and
decoding the to-be-decoded information based on the target number of information columns and a target lifting size, to obtain a decoded information bit sequence, wherein the target lifting size is determined based on the sets of lifting sizes.

3. The method according to claim 1 or 2, wherein
when the first information indicates Q code length intervals and P numbers of information columns, the Q code length intervals comprise a plurality of code length interval groups, the plurality of code length interval groups are associated with a same set of numbers of information columns, and the set of numbers of information columns associated with the plurality of code length interval groups comprises a plurality of numbers of information columns among the P numbers of information columns, wherein
Q and P are positive integers.

4. The method according to claim 1 or 2, wherein
a number of information columns associated with a first code length interval is a first number of information columns, and a number of information columns associated with a second code length interval is a second number of information columns, wherein each length value within the first code length interval is less than or equal to a first threshold, and each length value within the second code length interval is greater than the first threshold.

5. The method according to claim 1 or 2, wherein there are a first number *K*₁ of information columns and a second number *K*₂ of information columns, and *K*₁ is less than *K*₂;
a first code length interval is $\left(\frac{{K}_{1} \times {Z}_{max}}{z + 1}+1,\frac{{K}_{2} \times {Z}_{max}}{z + 1}\right]$, and a number of information columns associated with the first code length interval is *K*₂; and
a second code length interval is $\left(\frac{{K}_{2} \times {Z}_{max}}{z + 1}+1,\frac{{K}_{1} \times {Z}_{max}}{z}\right]$, and a number of information columns associated with the second code length interval is *K*₁, wherein
z is a positive integer, *Zₘₐₓ* is a first value, and the first value is a predefined maximum lifting size.

6. The method according to any one of claims 1 to 5, wherein that the number of information columns associated with the code length interval is determined based on the sets of numbers of information columns and/or the sets of lifting sizes comprises:
the number of information columns associated with the code length interval is determined based on the target lifting size, wherein the target lifting size is determined by comparing X first metrics, an x^{th} first metric among the X first metrics is determined based on the first value and an i^{th} lifting size in a first set of lifting sizes, the first set of lifting sizes is determined based on the sets of lifting sizes and the sets of numbers of information columns, the first value is the predefined maximum lifting size, the i^{th} lifting size corresponds to a j^{th} number of information columns in the sets of numbers of information columns, X is greater than or equal to 2, and x=1, 2, ..., X.

7. The method according to claim 6, wherein that the x^{th} first metric among the X first metrics is determined based on the first value and the i^{th} lifting size in the first set of lifting sizes comprises:
the x^{th} first metric is a difference between the first value and a first product;
the x^{th} first metric is a first ratio; or
the x^{th} first metric is a difference between 1 and the first ratio, wherein
the first product is a product of the i^{th} lifting size and the second metric, the second metric is determined based on the first value and the i^{th} lifting size, and the first ratio is a ratio of the first product to the first value.

8. The method according to claim 7, wherein
the second metric satisfies the following formula: ${δ}_{i} = \left⌊{Z}_{max}/{Z}_{i}\right⌋$, wherein $\left⌊⋅\right⌋$ represents rounding down.

9. The method according to claim 7 or 8, wherein
when the second metric is greater than a second threshold, the second metric is the second threshold.

10. The method according to any one of claims 6 to 9, wherein that the target lifting size is determined by comparing the X first metrics comprises:
the target lifting size is determined based on a minimum value or a minimum value of the X first metrics; or
the target lifting size is determined based on Y first metrics among the X first metrics, wherein a y^{th} first metric among the Y first metrics is less than or equal to a third threshold corresponding to the y^{th} first metric, or the y^{th} first metric among the Y first metrics is greater than or equal to the third threshold corresponding to the y^{th} first metric; Y is greater than or equal to 1; and y=1, 2, ..., Y.

11. The method according to any one of claims 6 to 10, wherein
a third threshold corresponding to the x^{th} first metric is determined based on the lifting size corresponding to the x^{th} first metric.

12. The method according to claim 11, wherein
the third threshold corresponding to the x^{th} first metric is any one of the following: 1/3Zc, 1/5Zc, 2/5Zc, or 1/4Zc; or
the third threshold corresponding to the x^{th} first metric is any one of the following: 1/3, 1/5, 2/5, or 1/4, wherein
Zc is the lifting size corresponding to the x^{th} first metric.

13. A communication method, comprising:
determining, based on an information bit sequence, sets of numbers of information columns associated with M base graphs corresponding to the information bit sequence and sets of lifting sizes associated with the M base graphs, wherein M is a positive integer greater than or equal to 2;
determining a target lifting size based on the sets of lifting sizes;
determining a target number of information columns based on the target lifting size and the sets of numbers of information columns; and
determining, from the M base graphs based on the target number of information columns, a base graph corresponding to the target number of information columns, wherein the base graph is used to encode the information bit sequence to obtain an encoded bit sequence.

14. A communication method, comprising:
obtaining to-be-decoded information from a transmitting device, and determining a length of an information bit sequence corresponding to the to-be-decoded information, sets of numbers of information columns associated with M base graphs corresponding to the information bit sequence, and sets of lifting sizes associated with the M base graphs, wherein M is greater than or equal to 2; and
decoding the to-be-decoded information based on a target number of information columns and a target lifting size, to obtain a decoded information bit sequence, wherein the target number of information columns and the target lifting size are determined based on the sets of numbers of information columns and the sets of lifting sizes.

15. The method according to any one of claims 1 to 14, wherein
determining a plurality of target information columns from the base graph based on the target number of information columns; and
encoding the information bit sequence based on the plurality of target information columns, wherein the plurality of target information columns comprise a punctured column of the base graph.

16. The method according to any one of claims 1 to 15, wherein
the M base graphs are a nested base graph, and the nested base graph comprises information columns of at least two base graphs.

17. The method according to any one of claims 1 to 16, wherein
a number of information columns in the set of numbers of information columns satisfies the following formula: u×v, wherein u is a positive integer, and v is a positive integer.

18. The method according to claim 17, wherein
the set of numbers of information columns is {22, 33, 44}.

19. The method according to any one of claims 1 to 18, wherein
a column group structure of one or more base graphs in the M base graphs is column-regular.

20. The method according to any one of claims 1 to 4, wherein
a number of groups of one or more base graphs in the M base graphs is greater than or equal to a maximum value of a second metric, wherein the number of groups of the base graph is a number of variable nodes in a group of variable nodes associated with the base graph, the second metric is determined based on a first value and a c^{th} lifting size in a set of lifting sizes associated with the base graph, and the first value is a predefined maximum lifting size; and
the c^{th} lifting size is, in the set of lifting sizes associated with the base graph, a minimum lifting size that supports a d^{th} number of information columns in a set of numbers of information columns associated with the base graph in meeting a first condition, the first condition is that a product of the d^{th} number of information columns and a lifting size in the set of lifting sizes associated with the base graph is greater than or equal to a fourth threshold, the fourth threshold is determined based on the first value and a minimum number of information columns in the set of numbers of information columns associated with the base graph, and c and d are positive integers.

21. The method according to claim 20, wherein
the fourth threshold is any one of the following: *K*₃ × *Zₘₐₓ*/2, *K*₃ × *Zₘₐₓ*/3, or *K*₃ × *Zₘₐₓ*/4, wherein *K*₃ is the minimum number of information columns, and *Zₘₐₓ* is the first value.

22. The method according to any one of claims 1 to 21, wherein
when sets of numbers of information columns associated with N base graphs among the M base graphs comprise one number of information columns, a ratio of numbers of information columns associated with the N base graphs is equal to a ratio of numbers of groups associated with the N base graphs, wherein N is less than or equal to M.

23. The method according to any one of claims 1 to 4, wherein
a maximum number of information columns in a set of numbers of information columns associated with the base graph is determined based on a first value and a second value, wherein the first value is a predefined maximum lifting size, and the second value is a maximum value of an information bit sequence length supported by the receiving device; or
the maximum number of information columns in the set of numbers of information columns associated with the base graph is determined based on a maximum value of a code rate supported by the base graph, a number of columns in a core parity-check region of the base graph, and a number of punctured columns of the base graph.

24. The method according to claim 23, wherein
the maximum number of information columns satisfies the following formula: ${K}_{max} \geq Z \frac{{K}_{infor}}{{Z}_{max}}$ ; or
the maximum number of information columns satisfies the following formula: ${K}_{max} \geq \frac{R \left(C-P\right)}{1 - R}$ , wherein
*Kₘₐₓ* is the maximum number of information columns, *K_{infor}* is the second value, *Zₘₐₓ* is the first value, a value of z is any one of the following: 1, 3/2, 4/3, 5/4, or 2, R is the maximum value of the code rate supported by the base graph, C is a parity-check number of a core region of the base graph, and P is the number of punctured columns of the base graph.

25. The method according to any one of claims 1 to 24, wherein
an interval between two adjacent numbers of information columns in the set of numbers of information columns associated with the base graph is determined based on the minimum number of information columns in the set of numbers of information columns associated with the base graph;
the interval between two adjacent numbers of information columns in the set of numbers of information columns associated with the base graph is 1; or
the interval between two adjacent numbers of information columns in the set of numbers of information columns associated with the base graph is 2.

26. The method according to claim 25, wherein
the interval between two adjacent numbers of information columns is any one of the following: $\left⌊\frac{{K}_{3}}{2}\right⌋ , \left⌈\frac{{K}_{3}}{2}\right⌉ , \left⌊\frac{{K}_{3}}{3}\right⌋ , \left⌈\frac{{K}_{3}}{3}\right⌉ , \left⌊\frac{{K}_{3}}{4}\right⌋$, or $\left⌈\frac{{K}_{3}}{4}\right⌉$, wherein $\left⌊⋅\right⌋$ represents rounding down, $\left⌈⋅\right⌉$ represents rounding up, and *K*₃ is the minimum number of information columns.

27. The method according to any one of claims 1 to 26, wherein
an intersection set of sets of numbers of information columns associated with any two of the M base graphs is an empty set; or
an intersection set of sets of numbers of information columns associated with at least two base graphs in the M base graphs is not an empty set.

28. A computer-readable storage medium, wherein the computer-readable storage medium stores computer instructions or a program; and when the computer instructions or the program is run on a computer, the transmitting device is caused to perform the communication method according to any one of claims 1, 3 to 12, or 15 to 27, a receiving device is caused to perform the communication method according to any one of claims 2 to 12, or 15 to 27, the transmitting device is caused to perform the communication method according to any one of claims 13, or 15 to 27, or the receiving device is caused to perform the communication method according to any one of claims 14 to 27.

29. A computer program product, wherein the computer program product comprises computer instructions; and when a part or all of the computer instructions are run, the communication method according to any one of claims 1, 3 to 12, or 15 to 27, the communication method according to any one of claims 2 to 12, or 15 to 27, the communication method according to any one of claims 13, or 15 to 27, or the communication method according to any one of claims 14 to 27 is performed.

30. A communication system, wherein the communication system comprises a transmitting device and a receiving device, the transmitting device is configured to perform the communication method according to any one of claims 1, 3 to 12, or 15 to 27, the receiving device is configured to perform the communication method according to any one of claims 2 to 12, or 15 to 27, the transmitting device is configured to perform the communication method according to any one of claims 13, or 15 to 27, and the receiving device is configured to perform the communication method according to any one of claims 14 to 27.
